(19) Europäisches Patentamt
European Patent Office
Office européen des brevets

(11) **EP 4 560 682 A1**

(12) **EUROPEAN PATENT APPLICATION**

(43) Date of publication:
**28.05.2025 Bulletin 2025/22**

(21) Application number: **23211553.5**

(22) Date of filing: **22.11.2023**

(51) International Patent Classification (IPC):
***H01J 37/147*** (2006.01) ***H01J 37/28*** (2006.01)

(52) Cooperative Patent Classification (CPC):
**H01J 37/1477; H01J 37/28;** H01J 2237/0453;
H01J 2237/1205; H01J 2237/153

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **KRECINIC, Faruk
5500 AH Veldhoven (NL)**

• **WIELAND, WIELAND
5500 AH Veldhoven (NL)**
• **MANGNUS, Albertus, Victor, Gerardus
5500 AH Veldhoven (NL)**
• **KONING, Johan, Joost
5500 AH Veldhoven (NL)**
• **LÖW, Peter
5500 AH Veldhoven (NL)**

(74) Representative: **ASML Netherlands B.V.
Corporate Intellectual Property
P.O. Box 324
5500 AH Veldhoven (NL)**

(54) **DEVICE AND METHOD FOR PROJECTING A PLURALITY OF CHARGED PARTICLE BEAMS**

(57) The present disclosure provides a charged particle element and relates apparatus and methods. In one arrangement, the element comprises a beam manipulator configured to operate on a plurality of charged particle beams in a beam grid. The beam manipulator comprises a plurality of plates. Each plate has two surfaces and a plurality of apertures. The plates comprises at least one curved-surface plate with a curved surface. The curved surface faces a facing surface of an adjacent plate. Deflections are applied to beams by controlling a potential difference between the curved surface and the facing surface.

Fig. 6

EP 4 560 682 A1

**Description**

FIELD

The present disclosure relates to charged particle elements, charged particle devices, spacers and associated methods.

BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal particles, e.g. electrons, to be emitted from the surface, such as secondary electrons, backscattered electrons or Auger electrons. The generated signal particles may be emitted from the material structure of the sample. By scanning the primary electron beam as the probing spot over the sample surface, signal particles can be emitted across the surface of the sample. By collecting these emitted signal particles from the sample surface, a pattern inspection tool may obtain data representing characteristics of the material structure of the surface of the sample. The data may be referred to as an image and may be rendered into an image.

To increase throughout, multi-beam systems are known that scan a plurality of beams, over the sample. Such a plurality of beams may be referred to as a multi-beam or beam grid in which the beams are arranged relative to each other Such systems may use charged particle-optical elements to apply lensing functions to the multi-beam. A collimator may be provided that deflects beams of the multi-beam so that the beams are more collimated. The collimator may, for example, deflect beams that are propagating along diverging paths relative to each other (e.g., due to originating from a common point-like source) such that the beams propagate along paths that are less diverging or which are parallel to each other and to a principal axis of the multi-beam. Such a collimator may be implemented using multiple sets of parallel plate deflectors for example as shown described in WO2021204734. Such a collimator may be referred to as a collimator array for example because the collimator operates on each beam of the beam grid differently. Each set contains rows of deflectors in which strengths of deflection increase as a function of distance from the principal axis. The sets have different orientations relative to each other (e.g., two sets of deflectors at 90 degrees each other or three sets of deflectors at 0 degrees, 60 degrees, and 120 degrees relative to each other). The different sets may be orientated relative to the principal axis and each other so they are angled with respect to each other by a principal angle (e.g. 60, 90 and 120 degrees).

Implementing charged particle-optical elements for multi-beam systems can be challenging, particularly for multi-beam systems having many beams. In the case of the parallel plate deflectors described above, the individual plates may for example need to be very long and thin, which can present fabrication challenges and/or lead to fragility.

SUMMARY

It is an object of the present disclosure to provide apparatus and methods that facilitate control of multi-beams of charged particles.

According to an aspect of the invention, there is provided a charged particle element for projecting a plurality of charged particle beams in a beam grid towards a sample, the element comprising: a beam manipulator configured to operate on a plurality of charged particle beams in a beam grid, the beam manipulator comprising a plurality of plates across paths of the beams, each plate having two surfaces in which are defined a plurality of apertures for operating on the beams and allowing the beams to pass through the plates, wherein: the plurality of plates comprises at least one curved-surface plate, the curved-surface plate being configured such that at least one of the two surfaces of the curved-surface plate is a curved surface and the curved surface faces a facing surface of an adjacent plate; and the beam manipulator is configured to apply deflections to beams of the beam grid by controlling a potential difference applied between the curved surface and the facing surface.

According to an aspect of the invention, there is provided a charged particle element for projecting a plurality of charged particle beams in a beam grid towards a sample, the element comprising: a plurality of plates positioned across a path of a plurality of beams of charged particles in a beam grid, each plate having two surfaces in which are defined a plurality of apertures for passage of the beams of the beam grid through the plates, the plurality of plates comprising an electron-optical component for operating on the beams of the beam grid, wherein: the plurality of plates comprise a curved-surface plate with two curved surfaces having curvature in all directions for all positions within at least portions of the curved surfaces, optionally within at least portions of the curved surfaces in which the apertures are defined.

According to an aspect of the invention, there is provided a spacer for supporting a plate of an electron-optical element for use in a multibeam inspection system, the spacer comprising a body having two surfaces in which are defined an aperture for the passage of a plurality of charged particle beams in a beam grid, wherein the body has a curvature representing a deviation from a planar form across one or both surfaces of the body.

According to an aspect of the invention, there is provided a method of projecting a plurality of charged particle beams in a beam grid towards a sample, the method comprising: operating on a plurality of charged particle beams in a beam grid using a plurality of plates across paths of the beams, each plate having two surfaces in which are defined a plurality of apertures for operating on the beams and allowing the beams to pass through the plates, wherein: the plurality of plates comprises at least one curved-surface plate, the curved-surface plate being configured such that at least one of the two surfaces of the curved-surface plate is a curved surface and the curved surface faces a facing surface of an adjacent plate; and the method comprises applying deflections to beams of the beam grid by controlling a potential difference applied between the curved surface and the facing surface.

According to an aspect of the invention, there is provided a method of projecting a plurality of charged particle beams in a beam grid towards a sample, the method comprising: electrostatically operating on a plurality of charged particle beams in a beam grid using a plurality of plates across paths of the beams, each plate having two surfaces in which are defined a plurality of apertures for operating on the beams and allowing the beams to pass through the plates, wherein: the plurality of plates comprise a curved-surface plate with two curved surfaces having curvature in all directions for all positions within at least portions of the curved surfaces, optionally within at least portions of the curved surfaces in which the apertures are defined.

According to an aspect of the invention, there is provided a charged particle element for adjusting the paths of different beams of a beam grid projected towards a sample the element comprising: a plurality of plates across paths of a plurality of beams of the beam grid, in the plurality of plates are defined a plurality of apertures for operating on the beams and allowing the beams to pass through the plates, adjoining plates of the plurality of plates having facing surfaces, wherein: one or both of the facing surfaces are curved; and the element is configured to apply a deflection to paths of different beams of the beam grid by controlling a potential difference applied between the respective facing curved surfaces.

According to an aspect of the invention, there is provided a module for charged particle column for projecting a plurality of beams in a beam grid towards a sample, the module comprising a charged particle element for adjusting the paths of different beams of the beam grid, the element comprising: a plurality of plates across paths of a plurality of beams of the beam grid, in the plurality of plates are defined a plurality of apertures for operating on the beams and allowing the beams to pass through the plates, adjoining plates of the plurality of plates having facing surfaces, wherein: one or both of the facing surfaces are curved; and the element is configured to apply a deflection to paths of different beams of the beam grid by controlling a potential difference applied between the respective facing curved surfaces.

## BRIEF DESCRIPTION OF FIGURES

The above and other embodiments of the present disclosure will become more apparent from the description of exemplary embodiments, taken in conjunction with the accompanying drawings.

**FIG. 1** is a schematic diagram illustrating an exemplary charged particle beam assessment (e.g. inspection) apparatus.
**FIG. 2** is a schematic diagram illustrating an exemplary multi-beam apparatus that is part of the exemplary charged particle beam assessment apparatus of **FIG. 1.**
**FIG. 3** is a schematic diagram of an exemplary multi-beam apparatus according to an embodiment.
**FIG. 4** schematically depicts a change in the propagation direction (or deflection) of a charged particle due to its deceleration by a uniform electric field between horizontally oriented parallel plates.
**FIG. 5** schematically depicts a change in the propagation direction (or deflection) of a charged particle in a case where the parallel plates of **FIG. 4** are inclined obliquely relative to the vertical.
**FIG. 6** is a schematic diagram of a charged particle element comprising curved-surface plates configured to collimate a beam grid.
**FIG. 7** is a magnified view of the portion of **FIG. 6** within the broken line box.
**FIG. 8** to **10** depict example configurations for plates of a beam manipulator that can be operated to implement a positive lens.
**FIG. 11** is a side view of an example spacer.

**FIG. 12** is a perspective view of the spacer of **FIG. 11.**

**FIG. 13** to **15** depict example combinations of pairs of curved-surface plates of a beam manipulator.

**FIG. 16** depicts a face of a peripheral clamp for clamping a curved-surface plate.

**FIG. 17** depicts an example pair of curved-surface plates having facing surfaces of corresponding curved topology (e.g. parallel opposing surfaces) and in which each plate has varying thickness (e.g. non-parallel opposite surfaces).

**FIG. 18** depicts an example charged particle-optical device comprising a charged particle element according to an embodiment of the disclosure, e.g., with a collimator array.

**FIG. 19** depicts a further example charged particle-optical device comprising a charged particle element according to an embodiment of the disclosure e.g. with a collimator array.

The figures are schematic. The schematic diagrams and views show the components described below. However, the components depicted in the figures are not to scale. Relative dimensions of components in drawings are exaggerated for ease of depiction. Within the following description of drawings the same or like reference numbers refer to the same or like components or entities, and only the differences with respect to the individual embodiments are described.

DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of substrate, devices (or columns), assemblies, arrays, apparatuses, systems and methods consistent with aspects and embodiments related to the invention as recited in the appended claims.

The enhanced computing power of electronic devices, which reduces the physical size of the electronic devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one defect can cause electronic device failure. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate signal particles, e.g. secondary electrons and/or back-scatter electrons. The detection apparatus captures the signal particles from the sample as the sample is scanned so that the SEM can create an image of the scanned area of the sample. For high throughput inspection, some of the inspection apparatuses use multiple focused primary beams, i.e. a multi-beam, of primary electrons. The component beams of the multi-beam may be referred to as sub-beams or beamlets or an array of primary beams. A multi-beam can scan different parts of a sample simultaneously. A multi-beam assessment (or inspection) apparatus can therefore inspect a sample at a much higher speed than a single-beam assessment (or inspection) apparatus. An implementation of a known multi-beam assessment system is described below.

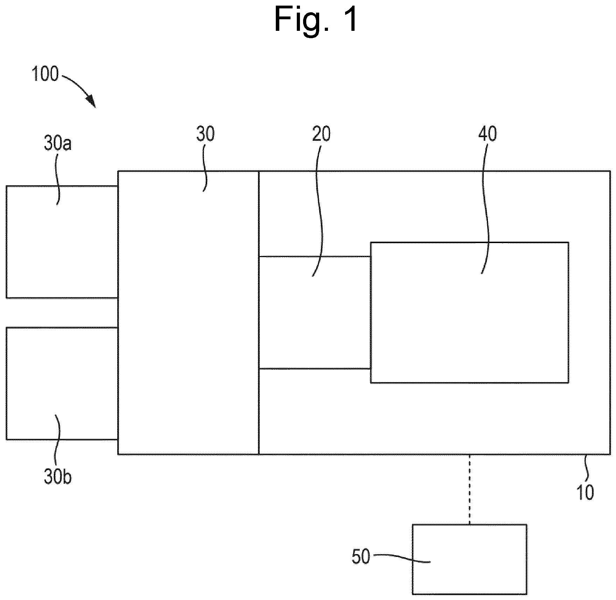

Reference is now made to **FIG. 1,** which is a schematic diagram illustrating an exemplary charged particle beam assessment system 100. The charged particle beam assessment system 100 of **FIG. 1** includes a main chamber 10, a load lock chamber 20, a charged particle beam apparatus 40 (which may otherwise be referred to as an electron beam apparatus, electron beam tool or charged particle beam tool), an equipment front end module (EFEM) 30 and a controller 50. The charged particle beam apparatus 40 is located within the main chamber 10. Such a charged particle apparatus 40 either is or comprises a charged particle device 41.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. After reaching the first pressure below the atmospheric pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second lower pressure. After reaching the second pressure, the sample is transported to the charged particle beam apparatus 40 by which it may be inspected. Depending on the configuration used, the second pressure may be deeper than between $10^{-7}$ to $10^{-5}$ mbar. A charged particle beam apparatus 40 may comprise a multi-beam charged particle optical device 41.

The controller 50 is electronically connected to the charged particle beam apparatus 40. The controller 50 may be a processor (such as a computer) configured to control the charged particle beam assessment (e.g. inspection) system 100. The controller 50 may include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment system 100 or it can be distributed over at least two of the component elements. While the present disclosure provides examples of the main chamber 10 housing a charged particle beam assessment system 100, it should be noted that embodiments of the disclosure in their broadest sense are not limited to a chamber housing a charged particle beam assessment system 100. Rather, it is appreciated that the foregoing principles may also be applied to other tools and other arrangements of apparatus, that operate under the second pressure.

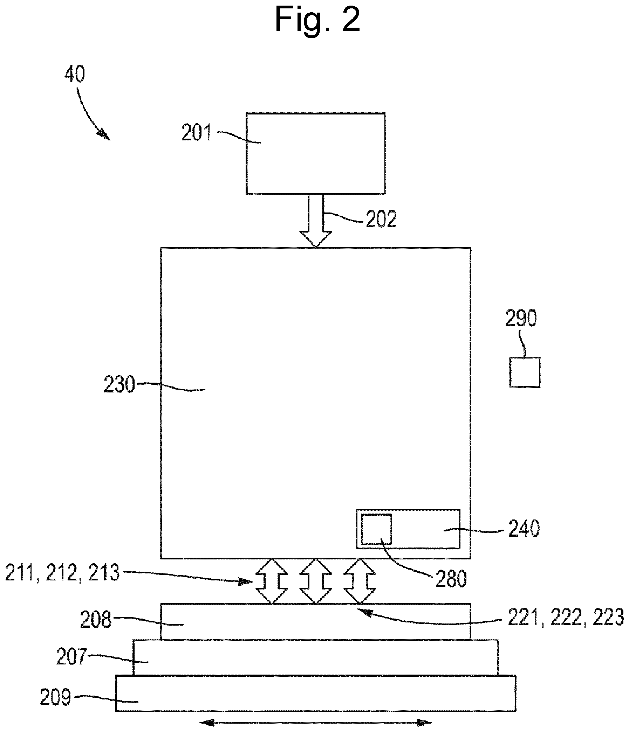

Reference is now made to **FIG. 2,** which is a schematic diagram illustrating an exemplary charged particle beam apparatus 40 that is part of the exemplary charged particle beam assessment system 100 of **FIG. 1.** The multi-beam charged particle beam apparatus 40 (also referred to herein as tool) comprises a charged particle source 201, a projection apparatus 230, an actuated stage 209, and a sample holder 207. The charged particle source 201 and projection apparatus 230 may together be referred to as an illumination apparatus. Features of the charged particle beam apparatus 40 not including the source 201 and the sample 208, sample holder 207 and actuated stage 209 may together be referred to as a charged particle device 41. The sample holder 207 is supported by actuated stage 209 so as to hold a sample 208 (e.g., a substrate or a mask) for inspection. The multi-beam charged particle beam apparatus 40 further comprises a detector array 240 (e.g. an electron detection device).

The controller 50 may be connected to various parts of the charged particle beam assessment system 100 of **FIG. 1.** The controller 50 may be connected to various parts of the charged particle beam apparatus 40 and/or the charged particle device 41 of **FIG. 2,** such as the charged particle source 201, the detector array 240, the projection apparatus 230, and the actuated stage 209. The controller 50 may perform various data, image and/or signal processing functions.

The controller 50 may also generate various control signals to govern operations of the charged particle beam assessment system 100, including the charged particle beam apparatus 40 and/or the charged particle device 41. The controller 50 may control the actuated stage 209 to move sample 208 during inspection of the sample 208. The controller 50 may enable the actuated stage 209 to move the sample 208 in a direction, for example continuously, for example at a constant speed, at least during sample inspection. The controller 50 may control movement of the actuated stage 209 so that it changes the speed of the movement of the sample 208 dependent on various parameters. For example, the controller 50 may control the stage speed (including its direction) depending on the characteristics of the inspection steps of scanning process.

The charged particle source 201 may comprise a cathode (not shown) and an extractor or anode (not shown). During operation, the charged particle source 201 is configured to emit charged particles (e.g. electrons) as primary charged particles from the cathode. The primary charged particles are extracted or accelerated by the extractor and/or the anode to form a primary charged particle beam 202. The charged particle source 201 may comprise multiple sources, such as described in US2023/0238215A1, which is hereby incorporated by reference at least with respect to the multiple sources and how they relate to multiple columns (or at least multiple charged particle devices 41) and their associated charged particle-optics.

The projection apparatus 230 is configured to convert the primary charged particle beam 202 into a plurality of beams 211, 212, 213 and to direct each beam onto the sample 208. Each beam may be referred to interchangeably herein as a beam, sub-beam or beamlet. The plurality of beams may be referred to as a multi-beam or beam grid. Although three beams are illustrated for simplicity, there may be many tens, many hundreds or many thousands of beams. Furthermore, although the present description and figures relate to a multi-beam system, a single beam system may be used instead in which the primary charged particle beam 202 is not converted into multiple beams. The beams of a multi-beam may be generally interchangeable with a single primary charged particle beam 202. For example, a single beam system may be used as described in US 2021/0319977.

The projection apparatus 230 may be configured to focus beams 211, 212, 213 onto a sample 208 for inspection and may form three probe spots 221, 222, 223 on the surface of sample 208. The projection apparatus 230 may be configured to deflect the primary beams 211, 212, 213 to scan the probe spots 221, 222, 223 across individual scanning areas in a section of the surface of the sample 208. In response to incidence of the primary beams 211, 212, 213 on the probe spots 221, 222, 223 on the sample 208, signal charged particles (e.g. electrons) are generated (i.e. emitted) from the sample 208 which include secondary signal particles and backscatter signal particles. The signal particles emitted from the sample, e.g. secondary electrons and backscatter electrons, may otherwise be referred to as charged particles, e.g. secondary charged particles and backscatter charged particles. Signal beams are formed of signal particles emitted from the sample. It will generally be understood that any signal beams emitted from the sample 208 will travel in a direction with at least a component substantially opposite to the charged particle beams (i.e. the primary beams), or will have at least a component of direction which is opposite to the direction of the primary beams.

The detector array 240 is configured to detect (i.e. capture) signal particles emitted from the sample 208. The detector array 240 is configured to generate corresponding signals which are sent to a signal processing system 280, e.g. to construct images of the corresponding scanned areas of sample 208. The detector array 240 may be incorporated into the projection apparatus 230, or may be separate therefrom, with a secondary optical column being provided to direct secondary signal particles to the detector array. The detector array may otherwise be referred to as a sensor array, and the terms "detector" and "sensor" and "sensor unit" are used interchangeably throughout the application.

The signal processing system 280 may comprise a circuit (not shown) configured to process signals from the detector array 240 to form an image. The signal processing system 280 could otherwise be referred to as an image processing system or a data processing system. The signal processing system may be incorporated into a component of the multi-beam charged particle beam apparatus such as the detector array 240 (as shown in **FIG. 2).** However, the signal processing system 280 may be incorporated into any components of the charged particle beam assessment system 100 (or charged particle beam apparatus 40 or charged particle device 41), for example as part of the projection apparatus 230 or the controller 50. The signal processing system 280 may be located outside of the structure that includes the main chamber shown in **FIG. 1.** The signal processing system 280 may include an image acquirer (not shown) and a storage device (not shown). For example, the signal processing system may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector array 240 permitting signal communication, such as an electrical conductor, optical fiber cable, portable storage media, IR, Bluetooth, internet, wireless network, wireless radio, among others, or a combination thereof. The image acquirer may receive a signal from the detector array 240, may process the data comprised in the signal and may construct an image therefrom. The image acquirer may thus acquire images of the sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The signal processing system 280 may include measurement circuitry (e.g., analog-to-digital converters) to obtain a distribution of the detected secondary signal particles. The electron distribution data, collected during a detection time window, can be used in combination with corresponding scan path data of each of primary beams 211, 212, 213 incident on the sample surface, to reconstruct images of the sample structures under inspection. The reconstructed images can be used to reveal various features of the internal or external structures of the sample 208. The reconstructed images can thereby be used to reveal any defects that may exist in the sample.

Known multi-beam systems, such as the charged particle beam apparatus 40 and charged particle beam assessment system 100 described above, are disclosed in US2020118784, US20200203116, US 2019/0259570 and US2019/0259564 which are hereby incorporated by reference.

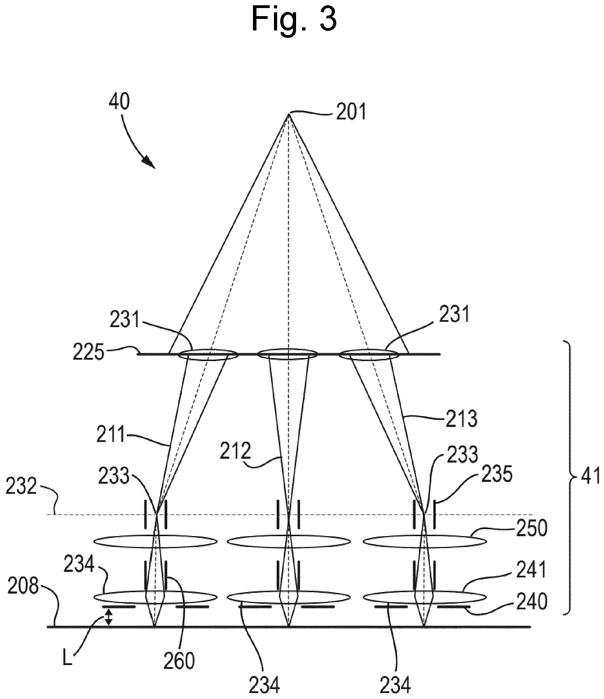

Components of an assessment apparatus 40 or charged particle device 41 (of, for example, or at least comprised in, an assessment system 100) are described below in relation to **FIG. 3** which is a schematic diagram of a charged particle beam apparatus 40. The charged particle beam apparatus 40 of **FIG. 3** may correspond to the multi-beam charged particle beam tool (also referred to herein as apparatus). The charged particle assessment apparatus may be, or may comprise, a charged particle optical device 41. The charged particle optical device 41 may include some, for example all, features between the source and facing a sample position, e.g. excluding the source 201, or all features described herein in for the charged particle assessment apparatus 40 such as depicted in **FIG. 3.** Note a sample position is the location or position that a sample 208 would have when held (or supported) by the sample holder 207.

The charged particle source 201 directs charged particles (e.g. electrons) toward an array of condenser lenses 231 (otherwise referred to as a condenser lens array) forming part of the projection system 230. The charged particle source 201 is desirably a high brightness thermal field emitter with a good compromise between brightness and total emission current. There may be many tens, many hundreds or many thousands of condenser lenses 231. The condenser lenses 231 may comprise multi-electrode lenses and have a construction based on EP1602121A1, which document is hereby incorporated by reference in particular to the disclosure of a lens array to split a primary beam of charged particles into a plurality of beams, with the array providing a lens for each beam. The array of condenser lenses 231 may take the form of at least two plates, acting as electrodes, with an aperture in each plate aligned with each other and corresponding to the location of a beam of the plurality of beams. At least two of the plates are maintained during operation at different potentials to achieve the desired lensing effect.

The charged particle beam apparatus 40 may comprise a beam limiting aperture array 225 in which are defined a plurality of apertures. The plurality of apertures are positioned to generate the beam grid of the plurality of beams. The beam limiting aperture array 225 may be integrated with, or directly adjacent to, the condenser lenses 231 as shown in **FIG. 3.** In other arrangements, the beam limiting aperture array 225 is separate from the condenser lenses 231.

In an arrangement the array of condenser lenses 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations.

Each condenser lens in the array may direct charged particles into a respective beam 211, 212, 213 which is focused at a respective intermediate focus 233. The intermediate foci 233 may be in a plane of intermediate focus, which may be referred to as an intermediate image plane. A position of the intermediate image plane (e.g., along a direction parallel to the principal axis of the beam grid) may be referred to as an intermediate image position. At the intermediate foci 233 are deflectors of a collimator (or collimator array) 235, for example at the plane of intermediate focus or at the position of the intermediate foci along the paths of the respective beams 211, 212, 213. Deflectors of the collimator 235 are configured to operate on respective beams 211, 212, 213, for example to bend respective beams 211, 212, 213 (or deflect paths of the respective beams) by an amount effective to ensure that the path of each beam is incident on the sample 208 e.g. substantially perpendicularly. Deflectors of the collimator 235 may also be referred to as collimators. Down beam of the intermediate foci 233 are a plurality of objective lenses 234 forming an objective lens array 241. Each objective lens 234 directs a respective beam 211, 212, 213 onto the sample 208. Objective lenses 234 can be configured to de-magnify the beams by a factor greater than 10, desirably in the range of 50 to 100 or more. In an embodiment, a control lens array 250 is provided between the deflectors of the collimator 235 and the objective lens array 241. The control lens array 250 provides additional degrees of freedom for controlling properties of the beams of the beam grid.

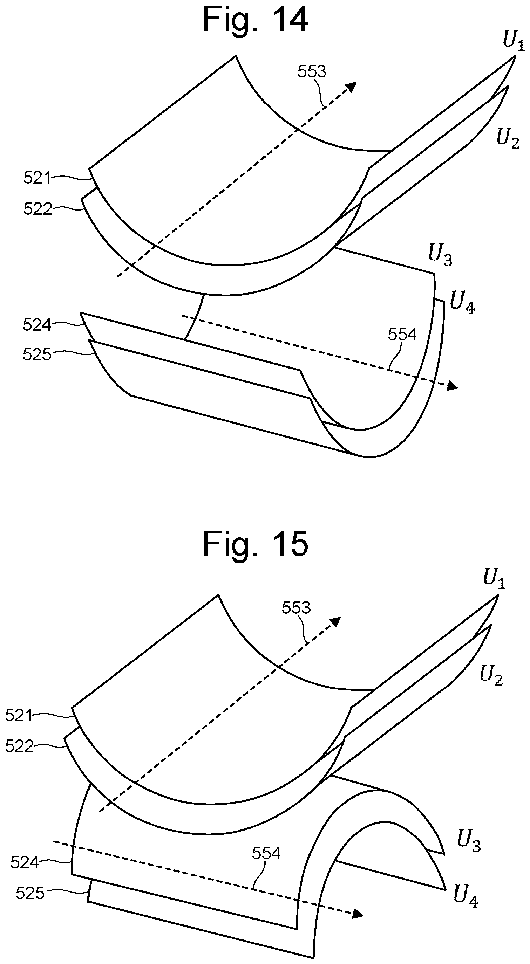

Voltage sources may be used to apply potentials to at least one electrode of the objective lens array 241, at least one electrode of the control lens array 250 and/or to the sample 208 to control projection of the beams, as described in US 2023/0290609A1, for example in figure 14, and in US2022/0196581A1. Variation in the potentials can be used for different landing energies to control the beam opening angle and/or the focus of the beam on the sample. The potentials may be controlled to accelerate or decelerate the beams.

The detector array 240 comprises a plurality of detectors. Each detector is associated with a corresponding beam of the beam grid. The detector array 240 may be positioned at a position along the beam path at any location between an up-beam position and a down-beam position along the beam path. The up-beam position is above the objective lens array and optionally any associated lens arrays such as a control lens array. The down-beam position is down beam of the objective lens array.

In an arrangement the detector array 240 is positioned between a control lens array 250 and the sample 208. The detector array 240 may be positioned between the objective lenses 234 and the sample 208, as shown in **FIG. 3.**

The detector array 240 may be positioned proximate and/or adjacent the sample, which reduces or avoids cross-talk between signal particles generated by different primary beams. Desirably, a distance 'L' as shown in **FIG. 3** between the detector array 240 and the sample 208 is approximately in the range of 20 to 100 $\mu$m. Arranging for the distance L to be small may promote detector efficiency and/or reduce cross-talk.

In an embodiment, the objective lens array 241 is an exchangeable module, either on its own or in combination with other elements such as the control lens array and/or detector array. The exchangeable module may be field replaceable, i.e. the module can be swapped for a new module by a field engineer. In an embodiment, multiple exchangeable modules are contained within the apparatus 40 and can be swapped between operable and non-operable positions without opening the apparatus 40.

In some embodiments, one or more aberration correctors are provided that reduce one or more aberrations in the beams of the beam grid. The one or more aberration correctors may be provided in any of the embodiments, e.g. as part of the charged particle device 41, and/or as part of an optical lens array assembly, and/or as part of an assessment apparatus 40. In an embodiment, each of at least a subset of the aberration correctors is positioned in, or directly adjacent to, a respective one of the intermediate foci 233 (e.g. in or adjacent to the intermediate image plane 232 or plane of intermediate focus). The beams of the beam grid have a smallest cross-sectional area in or near a focal plane such as the intermediate plane 232. This provides more space for aberration correctors than is available elsewhere, i.e. up beam or down beam of the intermediate plane (or than would be available in alternative arrangements that do not have an intermediate image plane).

In an embodiment, aberration correctors positioned in, or directly adjacent to, the intermediate foci 233 (or intermediate image plane 232) comprise deflectors to correct for the source 201 appearing to be at different positions for different beams of the beam grid. Correctors can be used to correct macroscopic aberrations resulting from the source that prevent a good alignment between each beam and a corresponding objective lens.

One or more scanning deflectors 260 may be integrated with, or directly adjacent to, one or more of the objective lenses 234 for scanning the beams 211, 212, 213 over the sample 208. In an embodiment, the scanning deflectors described in US 2010/0276606, which document is hereby incorporated by reference in its entirety, may be used.

The invention can be applied to various different apparatus architectures. For example, the charged particle beam apparatus may be a single beam apparatus, or may comprise a plurality of single beam charged particle devices (which may be referred to as single beam columns) or may comprise a plurality of multi-beam charged particle devices (which may be referred to as multi-beam columns). A plurality of charged particle devices (columns) may be arranged in an array which may number two to one hundred devices (columns) or more.

As mentioned in the introductory part of the description, it can be challenging to implement charged particle-optical elements for multi-beam systems, particularly where the multi-beam contains many beams. It may be desirable, for example, to provide multi-beams having many thousands of beams. The pitch between beams of the multi-beam cannot be reduced without limit due to fabrication limitations. As a consequence, charged particle-optical elements that operate on the multi-beam may need to become larger as the number of beams in the multi-beam increases. In a typical system having many thousands of beams, a region of a charged particle-optical element through which the multi-beam passes may need to be of the order of 10 mm across or larger for example in the range of 1 mm to 300 mm for example typically 2 to 20 mm. At the same time, physical features of the charged particle-optical elements may need to be very closely packed in order to operate on individual beams of the multi-beam in a desired way. This combination of factors can make fabrication difficult, have a negative impact on yield, and/or limit the number of beams that can be provided in the multi-beam. For the parallel plate deflectors discussed in the introduction, for example, individual plates may need to be very thin (e.g., having a smallest dimension of a few 10s of microns) and relatively long (e.g., having a largest dimension of 10mm or longer). It may be difficult to fabricate and/or coat such structures. The resulting structures may be relatively fragile, which may lead to low fabrication yield and/or vulnerability to failure. During manufacture of the structures, capillary forces may cause neighboring structures to stick to each other and/or otherwise cause damage to each other by contact. Environmental vibrations during manufacture may damage the structure. Strong control of environmental vibrations may be required during operation to achieve satisfactory performance. In a typical implementation, it may be necessary for example to control vibration amplitudes of features such as parallel plates to remain below a few nm. Closely spaced elements of the structure may need to be held at different electrical potentials (e.g., different rows of the parallel plate deflectors discussed in the introduction) from each other, leading to large electric fields. The large electric fields may increase a risk of electrical shorts and/or discharges, which may be caused for example by particle contamination. The large electric fields may cause elements to deform, which may reduce performance or need correcting for. Having many elements at different potentials requires complex wiring.

Embodiments of the present disclosure aim to address one or more the above challenges. At least some of these embodiments provide control of beams of a multi-beam by using curved surfaces of curved-surface plates to manipulate the beams. The curved surfaces allow different beams of the multi-beam to be controlled differently depending on where the beams interact with the curved surfaces. Each curved-surface plate contributes to control of beams across the beam grid without requiring different electrical potentials to be applied to different portions of the curved-surface plate and without requiring fragile structures to be formed in the curved-surface plate.

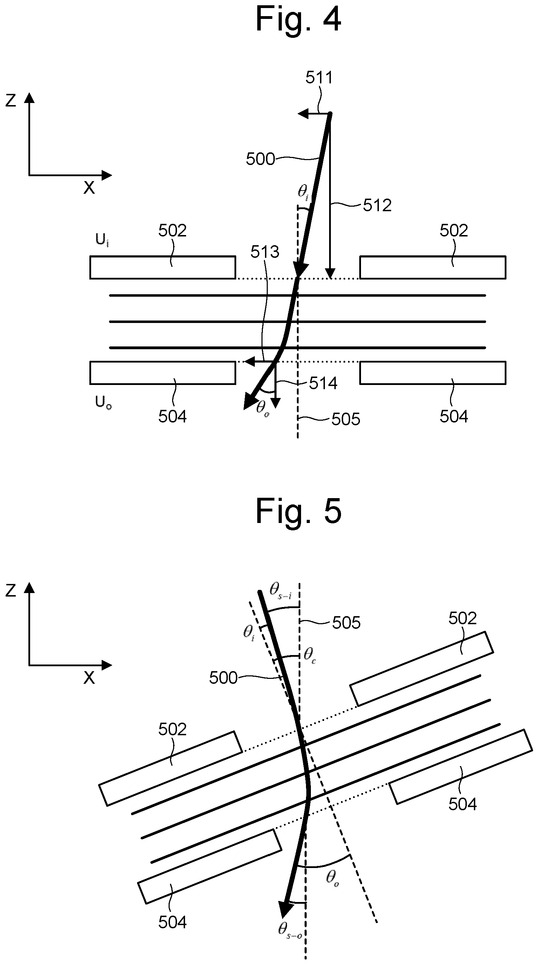

Principles of operation of the curved-surface plates are now described with reference to **FIG. 4** and **5.** When a charged particle (e.g., an electron) enters a space with an electric field a force is exerted on the charged particle and the charged particle accelerates or decelerates. If the charged particle is propagating at an angle with respect to the electric field (i.e., not parallel to the electric field), the direction of propagation of the charged particle will change. This is illustrated schematically in **FIG. 4** where an example trajectory 500 of a charged particle is shown by the thicker line in the figure. Two parallel plates 502 and 504 are held at respective potentials $U_i$ and $U_o$ to define a uniform electric field between the plates. ($U_i$ is the potential of the upbeam electrode; $U_o$ is the potential applied to the downbeam electrode). The electric field is oriented vertically downwards in the plane of the page (in the Z direction) and acts to decelerate the charged particle in the Z direction. The velocity of the charged particle upbeam of the electric field comprises an X component 511 and a Z component 512. The X component 511 and Z component 512 define an upbeam propagation angle $\theta_i$ of the charged particle. The velocity of the charged particle downbeam of the electric field comprises an X component 513 and a Z component 514. The X component 513 and the Z component 514 define a downbeam propagation angle $\theta_o$. The deceleration of the charged particle along the Z direction causes the magnitude of the Z component 514 to be smaller than the magnitude of the Z component 512. The electric field has no component parallel to the X direction and does not therefore affect the velocity of the charged particle along the X direction. The X components 511 and 513 are thus identical.

The reduction of the magnitude of the Z component 514 causes the downbeam propagation angle $\theta_o$ to be larger than an upbeam propagation angle $\theta_i$. The magnitude of the change in propagation angle, $|\theta_o - \theta_i|$, depends on the electric field strength. The change in angle can thus be controlled by controlling the potential difference between the plates 502 and 504.

For a paraxial beam (i.e., small propagation angles, e.g. small $\theta_i$ and $\theta_o$), the downbeam propagation angle $\theta_o$ is given by

$$\theta_o = \gamma \theta_i \qquad\qquad (1)$$

where $\gamma = \sqrt{U_i/U_o}$ is a proportionality parameter. This effect may be used to deflect a beam by a desired angle by introducing a tilt between the beam and the structure defining the electric field, as depicted schematically in **FIG. 5** where the structure defining the electric field comprises the parallel plates 502 and 504. **FIG. 5** shows that $\theta_i = \theta_c - \theta_{s-i}$ and $\theta_o = \theta_{s-o} + \theta_c$, where: $\theta_{s-i}$ is the angle of the incoming beam with respect to the optical axis 505 of the system; $\theta_{s-o}$ is the angle of the outgoing beam with respect to the optical axis 505 of the system; and $\theta_c$ is the tilt angle of the decelerating structure. In the example shown, the angle between plates of the parallel plates 502 and 504 and the Z axis (which may be the same as the optical axis 505) may be referred to as a local inclination. Substituting this into equation (1) yields that the angle of the outgoing beam may be expressed as:

$$\theta_{s-o} = \gamma(\theta_c - \theta_{s-i}) - \theta_c \qquad\qquad (2)$$

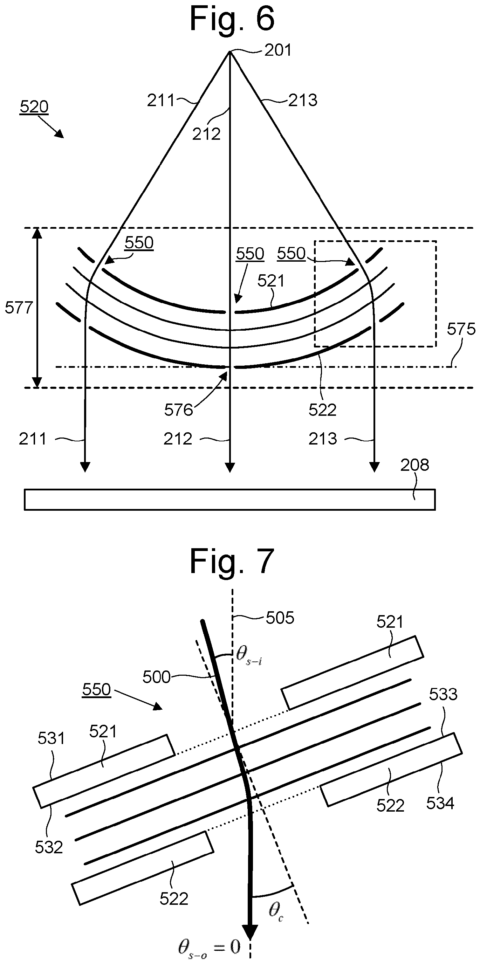

Embodiments of the present disclosure provide a charged particle element 520. **FIG. 6** schematically depicts example components of the element 520. **FIG. 7** is magnified view of a portion of the element 520 in **FIG. 6** that is surrounded by the broken line box. The element 520 is configured to project a plurality of charged particle beams 211, 212, 213 towards a sample 208. The plurality of charged particle beams may be referred to as a beam grid. The charged particle element 520 may be for adjusting the paths of different beams of the beam grid projected towards the sample 208. The element 520 may form part of any of the charged particle beam apparatuses 40 or charged particle devices 41 described above, for example with reference to **FIG. 1-3.** The multi-beam may be derived from charged particles emitted from a source 201. The element 520 comprises a beam manipulator or charged particle element. The beam manipulator is configured to operate (e.g., electrostatically) on the beams 211, 212, 213. The beam manipulator comprises a plurality of plates across (e.g., positioned across) paths of the beams 211, 212, 213. Apart from small curvatures in some or all surfaces of the plates, the plates may be substantially planar (i.e., planar with small deviations corresponding to the curvatures). Planes of the plates may cut through the paths of the beams 211, 212, 213. The planes of the plates may be substantially perpendicular to the paths of the beams 211, 212, 213 and/or perpendicular to a path of a beam grid defined by the beams 211, 212, 213. Each plate has two surfaces (e.g., major surfaces) in which are defined a plurality of apertures 550 for operating on the beams 211, 212, 213 and allowing the beams 211, 212, 213 to pass through the plates. The apertures define respective through holes for the beams 211, 212, 213. The plurality of plates may comprise an electron-optical component for operating on the beams of the beam grid. The electron-optical component may comprise an electrically conductive coating or material in and/or adjacent to the apertures 550. Voltages can be applied to the plates to define electric fields that operate on the beams of the beam grid.

The plurality of plates comprises at least one curved-surface plate. In the example of **FIG. 6** and 7, the plurality of plates comprises two curved-surface plates 521, 522. Each curved-surface plate 521, 522 is a plate configured such that at least one of the two surfaces (e.g., major surfaces) of the plate is a curved surface. A curved-surface plate may thus have one curved surface and one flat surface or two curved surfaces. In the example of **FIG. 6** and **7,** each of the two curved-surface plates 521, 522 has two curved surfaces. In the example shown, the two surfaces of each curved-surface plate are substantially parallel to each other, thereby defining a curved plate of substantially uniform thickness. In **FIG. 7,** the curved surfaces of the uppermost curved-surface plate are labelled 531 and 532 and the curved surfaces of the lowermost curved-surface plate 522 are labelled 533 and 534. In an embodiment, at least one of the curved surfaces of one of the curved-surface plates 521, 522 faces a facing surface of an adjacent plate. The facing surface of the adjacent plate may be a curved surface or a planar (flat) surface. In the example of **FIG. 6** and **7,** the curved surface 532 of the curved-surface plate 521 faces the curved surface 533 of the curved-surface plate 522. The curved surface 533 is thus an example of a facing surface of a plate adjacent to a curved-surface plate 521 (i.e., the surface that faces the curved surface 532 of the curved-surface plate 521).

The beam manipulator is configured to apply deflections to beams 211, 212, 213 of the beam grid by controlling a potential difference applied between the curved surface (e.g., curved surface 532) and the facing surface (e.g., the curved surface 533 that faces the curved surface 532 in the example of **FIG. 6** and **7**). The deflection may be controlled using the principles discussed above with reference to **FIG. 4** and **5.** The beam manipulator may comprise a controller and/or power supply and/or suitable electrical connections to allow the applied potential difference to be applied and controlled as needed. Thus, adjoining plates of the plurality of plates may have facing surfaces. One or both of the facing surfaces may be curved. The element may be configured to apply a deflection to paths of different beams of the beam grid by controlling a potential difference applied between the respective facing curved surfaces.

In some embodiments, as exemplified in **FIG. 6** and **7,** the beam manipulator is configured such that the deflection applied to each deflected beam 211, 212, 213 of the beam grid is defined by the position of the aperture 550 in the curved surface 532 that corresponds to that deflected beam. The position of the aperture 550 defines a local inclination (e.g., tilt angle $\theta_c$ relative to a principal axis of the beam grid) of the curved surface adjacent to the aperture 550 relative to a principal axis of the beam grid. The local inclination defines an orientation of the electric field adjacent to the aperture 550. As explained above with reference to **FIG. 4** and 5, the propagation direction of a beam and the orientation of the electric field adjacent to an aperture through which the beam passes determine the deflection applied to the beam. The deflection may thus be different for different beams due to differences in propagation angles and/or differences in local inclinations of portions of the curved surfaces 532 adjacent to the respective apertures 550 through which the beams pass. Thus, control of deflection is achieved in a way that can be different for different beams in the beam grid without requiring individual electrical connections to be made to define different voltages for the different beams and/or without requiring structurally fragile elements to be manufactured.

References are made herein to a principal axis of a beam grid. The principal axis is an axis parallel to a path of the beam grid. The principal axis may be located in a radial center of the beam grid (e.g., coinciding with a geometrical center of a region containing the beams of the beam grid when viewed along the principal axis). The principal axis may thus be aligned with a beam of the beam grid at or near a center of the beam grid. In the examples shown, the principal axis is typically vertical and in the plane of the page in the orientation of the figures. For example, in **FIG. 6** the principal axis coincides (lies along) the path of the central beam 212 of the beam grid.

In the example of **FIG. 6** and **7,** differences in propagation angles between the beams 211, 212, 213, and differences in local inclinations of the curved surfaces at the respective apertures 550 through which the beams pass, cause beams 211, 212, 213 to be deflected in different directions. Beam 211 is deflected towards the right in the figure; beam 213 is deflected towards the left; and beam 212 is substantially negligibly deflected if it is deflected at all (i.e. in principle it is not deflected). In this example, the applied deflections decrease an average divergence of beam paths from the principal axis of the beam grid, thereby applying a focusing effect to the beam grid. The element 520 may thus be configured to focus different paths of the beams of the beam grid. In the example shown, the focusing effect is such as to collimate the beam grid. Collimation is achieved when the downbeam propagation direction is substantially the same for all beams 211, 212, 213; that is the angle of the outgoing beams from the manipulator with respect to the optical axis is zero, $\theta_{s\text{-}o} = 0$. This can be achieved for all beams by suitable configuration of the curvature of the curved-surface plate 532. From equation (2) the following expression can be derived for the required local orientation $\theta_c$ (i.e., local inclination) of the curved surface 532 of the curved-surface plate 521 (defined here as the angle between the principal axis of the beam grid, and a local normal to the plane of the curved surface 532 for example of the charged particle element. For example the angle between the path of the beam grid (or along the Z direction in the orientation of the charged particle element such as shown in and described with reference to **FIG. 4-7**) and a local normal to the plane of the curved surface 532 of the charged particle element, such as indicated in **FIG. 5**):

$$\theta_c = \frac{\gamma}{\gamma - 1} \theta_{s-i} \tag{3}$$

Equation (3) gives the downbeam propagation angle $\theta_c$ as a function of the incoming beam angle $\theta_{s-i}$ with respect to the principal axis of the beam grid. For small angles the curved surface 532 is approximately spherical with a radius of curvature $r_c$ that is given by

$$r_c = r_0 \frac{\gamma - 1}{\gamma} \tag{4}$$

where $r_0$ is the distance from the collimator to the source 201 (or virtual source) of the beams 211, 212, 213.

In other embodiments, the beam manipulator is configured such that the applied deflections increase an average divergence of beam paths from the principal axis of the beam grid. In such an arrangement a defocusing effect is applied to the beam grid. The defocusing effect may for example be such that when a collimated beam grid is input to the beam manipulator in use the defocusing effect causes the beam manipulator to output an uncollimated beam grid.

In some embodiments, as exemplified in **FIG. 6** and **7,** the beam manipulator is configured such that the potential difference applied between the curved surface 532 and the facing surface (e.g., curved surface 533 of the adjacent plate) defines an electric field that is of uniform strength over the curved surface 532. Arranging for the electric field to be of uniform strength facilitates calculation of the effect of the electric field on the beams of the beam grid.

FIG. **6** and **7** show an example of a class of embodiment in which the element 520 comprises one or more pairs of curved-surface plates having facing curved surfaces. Each pair of curved-surface plates defines a respective pair of facing curved surfaces. In the example shown, the element 520 comprises one pair of curved-surface plates 521 and 522. The facing curved surfaces of the pair are the facing curved surfaces 532 and 533. The facing curved surfaces 532 and 533 of the pair are configured such that a separation between the facing curved surfaces 532 and 533 is the same at all positions on the facing curved surfaces 532 and 533. Making the separation between the facing curved surfaces 532 and 533 the same at all positions, and desirably small relative to the radius of curvature of the curved surfaces, allows an electric field of substantially uniform strength to be generated between the facing curved surfaces 532 and 533.

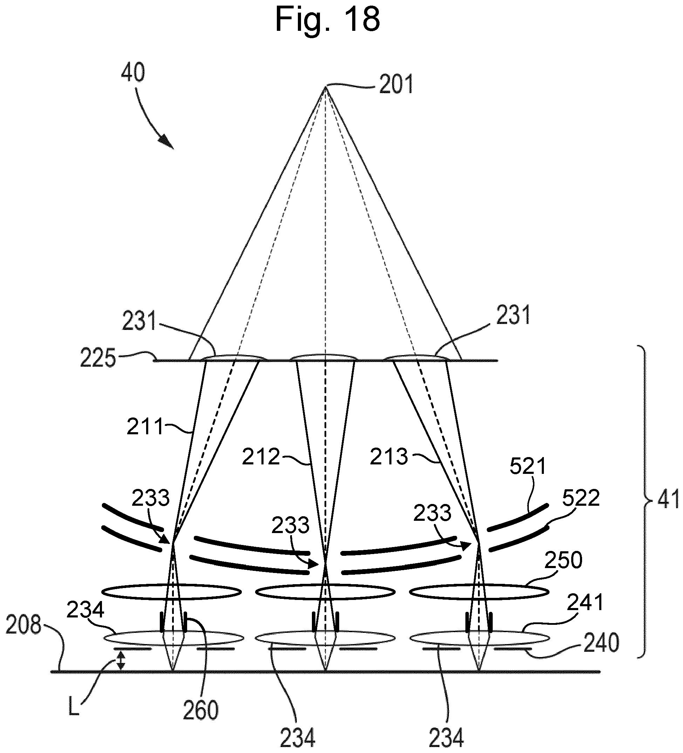

In some arrangements, as discussed in further detail below with reference to **FIG. 18,** the plurality of beams 211, 212, 213 of the beam grid may be focused to intermediate image positions. The depth of focus of the image in the intermediate image planes, indicated schematically by distance 577 in **FIG. 6,** may be relatively large in comparison to the curvatures and/or separation of the facing curved surfaces of the pair of curved-surface plates. The curved-surface plates of the beam manipulator can thus be positioned at a range of positions along the principal axis of the beam grid while still operating on beams substantially at the intermediate image positions of the beams (which may substantially be at a intermediate focus plane) .

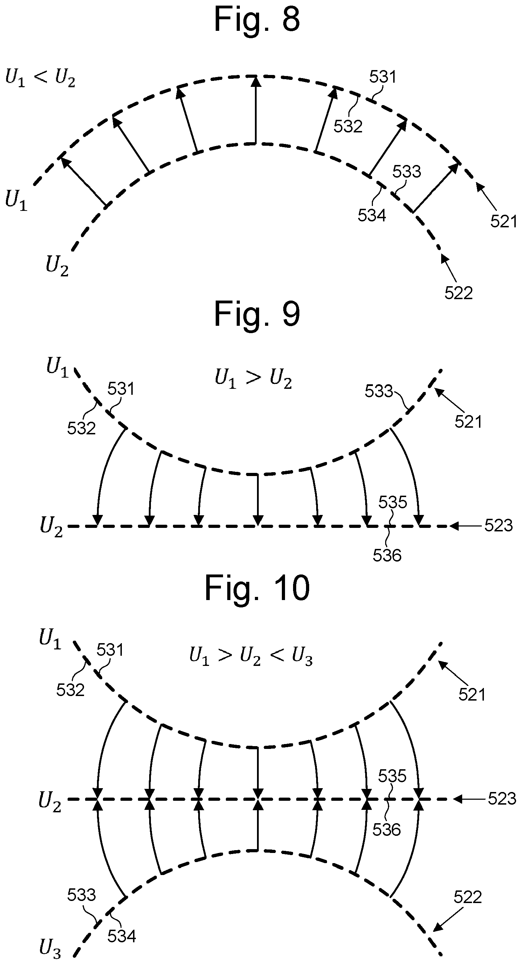

FIG. **8** to **10** depict example configurations for plates of a beam manipulator that can be operated to implement a positive lens.

FIG. **8** shows an example in which a separation between the facing curved surfaces 532, 533 of a pair of curved-surface plates 521, 522 is the same at all positions on the facing curved surfaces 532, 533. The example is similar to the configuration of **FIG. 6** and **7** except that the curved-surface plates 521, 522 in **FIG. 8** accelerate the charged particles and are orientated to be convex in the upbeam direction. The beam manipulator causes the curved-surface plates 521, 522 to accelerate the charged particles by applying voltages to the plates such that the potential $U_1$ of the upbeam electrode is less than the potential $U_2$, applied to the downbeam electrode $U_1 < U_2$.

FIG. **9** shows an example in which the plurality of plates of the beam manipulator comprises a curved-surface plate 521 and a flat plate 523. The flat plate 523 has two flat surfaces 535 and 536. The beam manipulator causes the plates 521 and 523 to decelerate the charged particles by applying voltages to the plates 521, 523 such that the upbeam electrode potential $U_1$ is larger than the downbeam electrode potential $U_2$, $U_1 > U_2$. **FIG. 9** is thus an example of a case where a curved surface of a curved-surface plate faces a flat facing surface 535 of adjacent plate 523.

FIG. **10** shows an example in which the plurality of plates of the beam manipulator comprises two curved-surface plates 521, 522 (e.g. an uppermost curved-surface plate 521 and lowermost curved-surface plate 522) and a flat plate 523 in between the two curved-surface plates 521, 522. Potentials are applied to the different plates: an upbeam electrode potential $U_1$; an intermediate electrode potential $U_2$; and a downbeam electrode potential $U_3$. The beam manipulator applies voltages to the plates such that the upbeam electrode potential $U_1$ is larger than the intermediate electrode potential $U_2$ which is smaller than the downbeam electrode potential $U_3$, $U_1 > U_2 < U_3$. This arrangement results in the charged particle being decelerated between the uppermost curved-surface plate 521 and the flat plate 523 and being accelerated between the flat plate 523 and the lowermost curved-surface plate 522.

In some embodiments, each curved-surface plate is formed by bending a planar (flat) plate. In an embodiment, the planar plate is formed from silicon, optionally with a metallic coating. Such a silicon plate may typically be less than 500 microns thick, optionally in the range of about 1 to 300 microns thick, optionally in the range of about 20 to 200 microns thick, optionally in the range of about 50 to 150 microns thick. It should be noted that a radius of curvature that is achievable, for example a minimum radius of curvature, may be a function of material properties (e.g. yield strength of silicon) and/or a thickness of the plates. Thus the minimum radius of curvature that may be achieved is a function of any of these parameters such as material properties of the plate (e.g. silicon) and the thickness of the plate. In an embodiment, apertures 550 are formed in the planar plate using etching and/or patterning using lithography. Forming the planar plate from silicon and/or forming the apertures 550 using etching and/or patterning by lithography allows the planar plate to be formed efficiently with high precision and reliability. Various techniques may be used for bending the planar plate to transform the planar plate into a curved-surface plate having the desired geometry. In some embodiments, a plate stressor is provided. The plate stressor is configured to apply stresses to the curved-surface plate to define a shape of the curved surfaces of the curved-surface plate. The plate stressor may, for example, deform a planar plate to provide the curved-surface plate. The plate stressor may be configured to support and/or secure in position the curved-surface plate within the beam manipulator. In an embodiment, the plate stressor comprises a peripheral clamp configured to apply the stresses via clamping of a periphery (which may be referred to as a peripheral portion) of the curved-surface plate. The peripheral clamp may comprise one or a pair of spacers 540 configured to be positioned on opposite sides of the curved-surface plate.

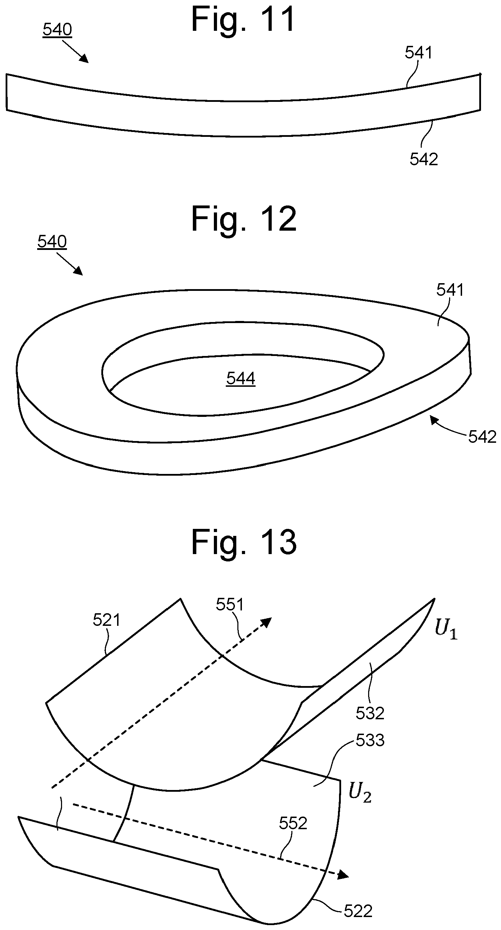

An example of such a spacer 540 is depicted in **FIG. 11** and **12. FIG. 11** is a side view of the spacer 540. **FIG. 12** is a perspective view of the spacer 540. As exemplified in **FIG. 11** and **12,** each spacer 540 comprises a body having two surfaces 541, 542 in which are defined an aperture 544 for the passage of a plurality of charged particle beams in a beam grid. The body has a curvature representing a deviation from a planar form across one or both surfaces 541, 542 of the body. The spacer may be an annulus. The spacer may be an annular body. The spacer may have a low aspect ratio; that is the height of the spacer (or dimension along the path of the beam grid) may be smaller than the width of the spacer (or dimension across the path of the beam grid). In a radial cross-section of the spacer, the annular body may have a low aspect ratio. The radial width of the body may have a larger dimension than the dimension in an axial direction (or of the path of the beam grid). The spacers 540 may be shaped such that when the curved-surface plate (which may or may not have a curved surface when not clamped) is clamped between the spacers 540 the spacers 540 cause the curved-surface plate to deform into a desired shape defined by shapes of the spacers 540. The spacers 540 (e.g., two different individual spacers) may have the same shape as each other. The spacers may be shaped to suit the required curvature of the curved surface of the curved-surface plates which the spacers are intended to clamp. The curved-surface plate may be attached to the spacer 540 in various ways, including clamping between two spacers 540 or by other mechanical fixation techniques. For example the curved-surface plate may be fixed to a single spacer 540 (or to both spacers 540 of a pair of spacers 540) by adhesion such as by gluing or welding.

Forming curved-surface plates by bending can be achieved more easily if the resulting curvature is one-dimensional, such as bending into a shape comprising a portion of a cylinder. A surface having one-dimensional curvature is a surface that satisfies the criterion of having zero curvature in one particular direction (i.e., being flat along a line parallel to the particular direction) at all points on the surface. (A surface with one-dimensional curvature has a surface topology which is constant (or non-variable) in direction and is continually varying to provide a curved surface of a characteristic such as a cylindrical surface.) In the case of a cylindrical surface, the surface has zero curvature in a direction parallel to the axis of the cylinder at all points on the surface. Bending a flat plate into a curved plate with such one-dimensional curvature can be achieved with higher accuracy than bending the flat plate into more general shapes, because the shape of the plate is fully determined during bending by the shape of the spacer 540 because the spacer provides a supporting structure of the target shape (e.g. cylindrical surface) even at the periphery of the supporting structure. The risk of failure is lower than bending the plate to curvatures with more complex characteristics. Such failure can be inconsistent bending (so the resulting curved surface plate is not of a target curvature perhaps because the spacer fails to provide a supporting structure to determine adequately the plate as it is bent); or catastrophic failure of the plate. The spacer 540 discussed above with reference to **FIG. 11** and **12** is configured to bend a flat plate into a curved-surface plate having two curved surfaces with one-dimensional curvatures. A curved surface having a curvature that is more complex (i.e. more complex characteristics) than the one-dimensional curvature mentioned above (i.e., which does not satisfy the criterion for one-dimensional curvature mentioned above) may comprise a surface having a two-dimensional curvature. As described below, it is also possible to bend a flat plate into a shape that provides a surface having a two-dimensional curvature.

Using curved surfaces having one-dimensional curvature determines the nature of deflections that can be achieved by each curved surface relative to using surfaces having two-dimensional curvature. For example, a plate of a manipulator with a curved surface that has one-dimension of curvature deflects beams relative to the path of the beam grid in a first direction across the beam path, e.g. an x axis of the charged particle device; the plate does not operate on the direction of the beams of the beam grid in a different direction across the beam path that may be orthogonal to the first direction, such as e.g. a y axis of the charged particle device. Curved surfaces having one-dimensional curvature may, for example, be configured to perform lensing (focusing or defocusing) relative to a line focus rather than a point focus. This restriction can, however, be overcome by using multiple curved surfaces having different orientations relative to each other. For example, a combination of two or more curved surfaces having one-dimensional curvature and with their directions of curvature oriented with respect to each other at angles that may be the principal axes of the beam grid. Such principal axes may be at 90 degrees relative to each other for example for a beam grid with a rectangular arrangement or at 0 degrees, 60 degrees and 120 degrees in the case of a hexagonal beam grid. A rectangular arrangement may be suited to an arrangement with at least two curved surfaces (e.g. two curved plates) for example in multiples of two. An arrangement using the principal axes of a hexagonal beam grid may be suited to an arrangement with three or more curved surfaces (for example three sets of multiples of two) for example in which different curved surfaces are aligned which different principal axes of the beam grid. Such an arrangement may be able to perform lensing (focusing or defocusing) relative to a point focus.

In some embodiments, the plurality of plates of the beam manipulator comprises one or more pairs of curved-surface plates having facing curved surfaces. Each pair of curved-surface plates thus defines two curved surfaces that face each other. The facing curved surfaces of each pair of curved-surface plates may have one-dimensional curvature. Thus, both of the facing curved surfaces may have zero curvature (i.e., be straight or substantially straight, for example within measurement tolerances) along a respective direction at all points on the facing curved surface. The respective directions may the same or different. At least two of the plates may be cylindrically curved (e.g., to form portions of a cylinder), in different axes (e.g., with non-parallel axes of cylindrical symmetry) or the same axes (e.g., with parallel axes of cylindrical symmetry) across the beam path.

**FIG. 13** depicts an example arrangement in which the respective directions of zero curvature 551, 552 are different for facing surfaces 532, 533 of a pair of curved-surface plates 521, 522. In this example, an upbeam electrode potential $U_1$ and a downbeam electrode potential $U_2$ are applied to the plates to define a potential difference and

EP 4 560 682 A1

associated electric field between the plates. The pair defines facing curved surfaces 532 and 533. The facing curved surface 532 of the uppermost curved-surface plate 521 has zero curvature along a first direction 551 at all points on the facing curved surface 532. The facing curved surface 533 of the lowermost curved-surface plate 522 has zero curvature along a second direction 552 at all points on the facing curved surface 533. The first direction is different to the second direction. In embodiments of this type, the first direction and the second direction may have different rotational orientations. The rotational orientations may be defined (e.g., as a rotational angle) relative to an axis (e.g., an axis of rotation) along the path of the beam grid, optionally relative to the principal axis of the beam. Providing facing curved surfaces that are rotated relative to each other in this manner provides additional degrees of freedom for deflecting beams of the multi-beam. The first direction may for example be rotated by an angle that may be the principal angle of the beam grid, such as 60, 90 or 120 degrees, relative to the second direction about the principal axis. The additional degrees of freedom may be used for example to enhance a focusing or defocusing effect applied by the facing curved surfaces.

FIG. 14 and 15 depict example arrangements in which respective directions of zero curvature are the same for facing curved surfaces of one or more pairs of curved-surface plates. For each such pair, a respective pair of facing curved surfaces thus has zero curvature along substantially the same common direction 553, 554 at all points on the facing curved surfaces. In each of FIG. 14 and 15, the pair of curved-surface plates labelled 521 and 522 define facing curved surfaces that both have zero curvature along the common direction 553. Similarly, the pair of curved-surface plates labelled 524 and 525 in each figure define facing curved surfaces that both have zero curvature along the common direction 554. A separate potential may be applied to each curved-surface plate. A first potential applied to curved-surface plate 521 may be $U_1$. A second potential applied to curved-surface plate 522 may be $U_2$. A third potential applied to curved-surface plate 524 may be $U_3$. A fourth potential applied to curved-surface plate 525 may be and $U_4$. Each such pair of facing curved surfaces may be configured such that a separation between the facing curved surfaces is the same at all positions on the facing curved surfaces. This may provide a substantially uniform electric field strength between the facing curved surfaces. Thus, one or more pairs of parallel curved-surface plates may be provided. The different orientations of the facing curved surfaces provides additional degrees of freedom for focusing or defocusing in a similar way to the arrangement of FIG.13 but the use of pairs of parallel curved-surface plates allows the electric field configurations to be simpler than in the arrangement of FIG. 13, which may facilitate design and/or control of the beam manipulator.

As exemplified in FIG. 14 and 15, a plurality of the pairs of curved-surface plates may be provided. As also exemplified in FIG. 14 and 15, two of the pairs may have different rotational orientations relative to each other. The different orientations may be defined relative to the path of the beam grid and/or relative to a principal axis of the plurality of beams of charged particles of the beam grid. As mentioned above, the different orientations may provide additional degrees of freedom for deflecting beams of the multi-beam.

The plurality of pairs of curved-surface plates may comprise a first pair and a second pair. The first pair in FIG. 14 and 15 may be considered to be the uppermost pair in the figures. The first pair thus consists of curved-surface plates 521 and 522. The second pair in FIG. 14 and 15 may be considered to be the lowermost pair in the figures. The second pair thus consists of curved-surface plates 524 and 525. In the examples shown, the facing curved surfaces of each pair are configured such that a separation between the facing curved surfaces is the same at all positions on the facing curved surfaces. As mentioned above, making the separation between the facing curved surfaces the same at all positions allows an electric field of uniform strength to be generated between the facing curved surfaces.

The facing surfaces of the first pair have zero curvature along a first common direction 553 at all points on the facing surfaces. The facing surfaces of the second pair have zero curvature along a second common direction 554 at all points on the facing surfaces. In embodiments of this type, the first common direction 553 may be perpendicular or oblique relative to the second common direction 554 (e.g., rotated relative to each other relative to a principal axis of the beam grid, optionally by an angle such as the principal angle of the beam grid, for example 60 degrees, 90 degrees or 120 degrees). In the examples shown, the first and second common directions 553 and 554 are perpendicular to each other. In a variation of this embodiment, three pairs of the curved-surface plates may be provided, with each pair having a one-dimensional curvature defined respectively relative to first, second and third non-parallel common directions. In an embodiment, the first, second and third common directions may, for example, be rotationally positioned relative to each other at the principle angle of the beam grid, for example 0 degrees, 60 degrees, 90 degrees and 120 degrees (e.g., in a plane perpendicular to a principal axis of a beam grid) to provide focusing or defocusing of a hexagonal beam grid.

In an embodiment, the facing surfaces of the first pair are convex in an opposite direction to the facing surfaces of the second pair, as exemplified in FIG. 15. In the example shown, the facing surfaces of the first pair of curved-surface plates 521, 522 are convex in a downbeam direction; that is as shown in FIG. 15 bowing outwards in a vertically downwards direction or bending or curving downwards in the vertical direction. This is intended to correspond to the path the beam grid (i.e. the path of the beam grid propagation). The facing surfaces of the second pair of curved-surfaces plates 524, 525 are shown convex in an upbeam direction; that is as shown in FIG. 15 bowing outwards in a vertically upwards direction or bending or curving upwards in the vertical direction. This arrangement desirably allows the electric fields between the respective pairs of facing surfaces to be opposite in sign while the two pairs apply the same type of focussing action on the beam grid (e.g., both focussing or both defocussing). The element may thus accelerate charged particles between facing surfaces of one of the two pairs and decelerate charged particles between facing surfaces of the other of the two pairs. For example, charged particles may be decelerated by the first pair and accelerated by the second pair. The oppositely orientated curvatures mean that the same type of focussing action can be performed on the beams despite the oppositely oriented electric fields (e.g., both increasing an average divergence of beam paths or both decreasing an average divergence of beam paths).

Thus, the arrangements of **FIG. 14** and **FIG. 15** can both be driven to have the same effect on beam paths of the beam grid in terms of controlling the trajectories of the beam paths. However, while in **FIG. 14** the first and second pairs of curved-surface plates both decelerate charged particles and may lead to a relatively low beam energy at the output, in **FIG. 15** the beam energy can be higher or even unchanged relative to the beam energy upbeam of the first and second pairs of curved-surface plates. Further, the curvature of the pairs of curved-surface plates 521, 522, 524, 525 of the arrangement shown in **FIG. 15** and the potentials applied to them may be such that the collimation strength is the same in both directions. The both directions may, for example, refer to an x direction and a y direction in a Cartesian frame of reference in which the beam grid propagates parallel to the z direction. In such an arrangement the curvature of the first pair and second pair (which are relative to each other an upper pair and a lower pair along the path of the beam grid) have the same magnitude of curvature but of opposite sign. The potentials applied to the plates may be such that the potential $U_1$ applied to the upper plate 521 of the first pair corresponds to (e.g., is substantially equal to) the potential $U_4$ applied to the lower plate 525 of the second pair. The potential $U_2$ applied to the lower plate 522 of the first pair corresponds to (e.g., is substantially equal to) the potential $U_3$ applied to the upper plate 524 of the second pair.

The curvature of each facing curved surface may be described in terms of deviations from a reference plane. An example of such a reference plane is labelled 575 in **FIG. 6.** Thus, a curvature of each facing curved surface of one or more of the pairs of curved-surface plates may be such that the facing curved surface deviates from a reference plane 575. The reference plane 575 may be defined as a plane perpendicular to the path of the beam grid (e.g., a horizontal plane when the beam grid propagates vertically, as in the example of **FIG. 6**) and passing through the respective facing curved surface (e.g., the upper facing surface of the curved-surface plate 522 in the example of **FIG. 6**) where the facing curved surface intersects a principal axis of the beam grid (at intersection point 576 in the example of **FIG. 6**). The deviation from the reference plane 575 may be defined, for each portion of the facing curved surface, as a separation between the reference plane 575 and the portion of the facing curved surface in a deviation direction. The deviation direction is a direction parallel to the principal axis of the beam grid (e.g., a vertical direction in the example of **FIG. 6**). The deviation varies in magnitude as a function of distance of the portion of the facing curved surface from the principal axis of the beam grid according to the curvature of the facing curved surface.

In an embodiment, each of one or more of the facing curved surfaces is configured such that the deviations from the reference plane are in the same direction for all portions of the facing curved surface. Thus, the deviations may all be in a down-beam direction or may all be in an upbeam direction, for a given facing curved surface. The deviations may be such that a radius of curvature of the surface always has the same sign (e.g., such that the shape of the facing surface is undulation free). In the arrangement of **FIG. 13,** for example, all portions of the downbeam facing surface of curved-surface plate 521 deviate from a respective reference plane (not shown) in an upbeam direction. The downbeam facing surface of curved-surface plate 521 may thus be described as curving upwards away from the reference plane 575. All portions of the upbeam facing surface of curved-surface plate 522 also deviate from a respective reference plane 575 in an upbeam direction. **FIG. 13** is thus an example of an embodiment in which the facing curved surfaces of one of the pairs of curved-surface plates are configured such that the deviations from the respective reference plane are in the same direction to each other.

Further examples are shown in **FIG. 14** and **FIG. 15**. In **FIG. 14,** all facing curved surfaces shown deviate from horizontal reference planes in the same direction (vertically upbeam). In **FIG. 15,** facing curved surfaces of curved surface plates 521 and 522 deviate from horizontal reference planes in the same direction (vertically upbeam) and facing curved surfaces of curved surface plates 524 and 525 deviate from reference planes in the same direction (vertically downbeam). These are examples of arrangements in which at least two of the plurality of plates are curved in the same direction.

As mentioned above, the facing curved surfaces may have one-dimensional curvature. One dimensional curvature may be defined as a curvature for which deviations from the respective reference plane are uniform as function of position in the facing curved surface along a common direction for all portions of the facing curved surface. As discussed above, this may facilitate forming of the curved-surface plates by bending. Alternatively, as described in further detail below, the facing curved surfaces may have two-dimensional curvature. Two-dimensional curvature may be defined as a curvature for which deviations from the respective reference plane vary as a function of position in all directions for at least one portion of the facing curved surface. Thus, at least one of the plates may be curved in two different directions across the beam paths.

In some embodiments, as exemplified in **FIG. 14 and FIG. 15**, the facing curved surfaces of one of the pairs of curved-surface plates are configured such that a separation between the facing curved surfaces of the pair is the same at all positions on the facing curved surfaces. Arranging for the separation to be uniform ensures that the electric field is substantially uniform. This is the case for example for the facing curved surfaces associated with the pair of curved-surface plates 521 and 522 of **FIG. 14** and **FIG. 15**, and for the facing curved surfaces associated with the pair of curved-surface plates 524 and 525 of **FIG. 14** and **FIG. 15**.

In some embodiments, the facing curved surfaces of one of the pairs of curved-surface plates are configured such that the deviations from the respective reference plane are in opposite directions to each other for all portions of the facing curved surfaces. Facing surfaces are thus curved in opposite directions. This is the case in this arrangement for example for the facing curved surfaces associated with the pair of curved-surface plates 522 and 524 of **FIG. 15.** The facing curved surfaces of one of the pairs of curved-surface plates may for example be configured such that the deviations from the respective reference plane are in opposite directions to each other and substantially equal in average magnitude. For example curved-surface plates 522 and 524 may have substantially the same shape but differ only in respect of their rotational orientation around a principal axis of the beam grid. Curved-surface plates 522 and 524 may both be portions of a cylinder having the same radius for example. Typically, an electrode potential $U_2$ applied to the curved-surface plate 522 and an electrode potential $U_3$ applied to the curved-surface plate 524 will be substantially equal. In this case, the electric field may be substantially zero in between the curved-surface plate 522 and the curved-surface plate 524. This may be desirable to avoid complicated field configurations and thereby simplify operation of the arrangement. In the arrangement of **FIG. 15** a potential difference may be applied between curved-surface plate 521 and curved-surface plate 522 by setting respective electrode potentials $U_1$ and $U_2$ to be different from each other. A potential difference may be applied between curved-surface plate 524 and curved-surface plate 525 by setting respective electrode potentials $U_3$ and $U_4$ to be different from each other. A polarity of the difference between electrode potentials $U_1$ and $U_2$ may be set so that electrons are decelerated between curved-surface plate 521 and curved-surface plate 522 (i.e., with $U_1 > U_2$). A polarity of the difference between electrode potentials $U_3$ and $U_4$ may be set so that electrons are accelerated between curved-surface plate 524 and curved-surface plate 525 (i.e., with $U_3 < U_4$). Thus, different plates may be curved so as to be configured to maintain the beam energies of the different beams.

In some embodiments, the curved surface of each of one or more of the at least one curved-surface plates has non-zero curvature in all directions along the curved surface for all positions within at least a portion of the curved surface. Such a curved surface may be described as having two-dimensional curvature. In an embodiment, the curved surface is axi-symmetric relative to principal axis of the beam grid. The principal axis may thus be the axis of cylindrical symmetry.

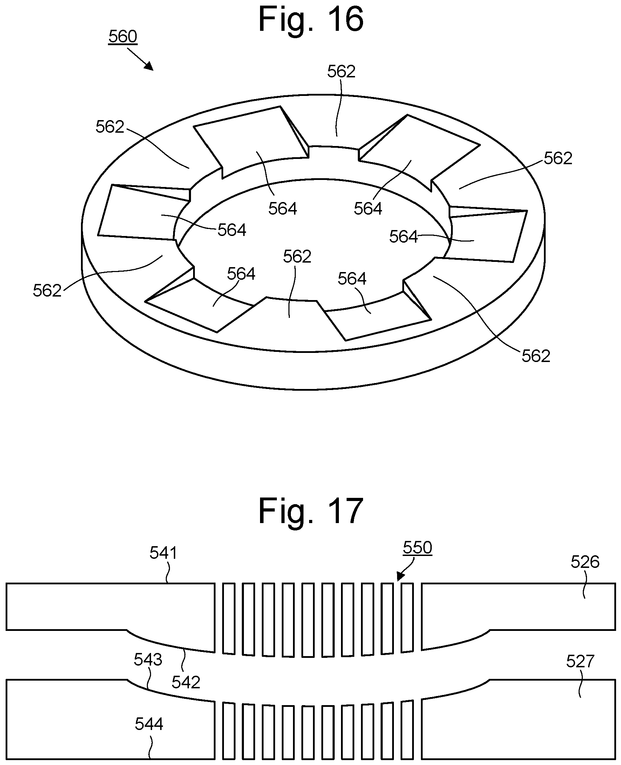

**FIG. 16** depicts an example face 560 (which may be a face of a spacer) of a peripheral clamp of a plate stressor for clamping a curved-surface plate to define the shape of a curved surface of the curved-surface plate. The plate stressor is configured (e.g., using the peripheral clamp) to define the shape of one or both of the curved surfaces of the curved-surface plate to have curvature in all directions along the curved surface or curved surfaces for all positions within at least a portion of the curved surface or curved surfaces. The plate stressor may thus be configured to deform the curved-surface plate such that one or both of the curved surfaces of the plate have a two-dimensional curvature. In an embodiment, the peripheral clamp is configured to clamp a peripheral portion of the curved-surface plate to apply a deformation to the curved-surface plate desirably at the peripheral portion.

The deformation may comprise displacing a plurality of displacement portions of the peripheral portion. Each displacement portion may for example be displaced in an axial direction parallel to the path of the beam grid. In the face 560 of the peripheral clamp shown in **FIG. 16,** for example, the interleaved combination of the flat portions 562 and indented portions 564 may cause relative axial displacement of displacement portions of the curved-surface plate that are aligned with the indented portions 564. In an embodiment, the displacement portions are substantially identical to each other and/or distributed uniformly around a periphery of the curved-surface plate and/or distributed so as to have rotational symmetry of order greater than one relative to a principal axis of the beam grid.

For example, the peripheral clamp may comprise a complementary face or spacer (not shown) that has a shape complementary to the shape of the face 560 shown. The complementary face or spacer may for example comprise flat portions configured to be aligned with the flat portions 562 and raised portions configured to be aligned with the indented portions 564. Pressing a curved-surface plate between the face 560 and the complementary face or spacer may cause the displacement portions of the curved-surface plate to be pressed into respective indented portions 564.

Stresses resulting from the axial displacement of the displacement portions cause a central region of the curved-surface plate to deform into a shape having two-dimensional curvature. Thus, the peripheral clamp may deform a peripheral portion of the curved-surface plate in order to impart a deformation defining curvatures and/or the shapes of the curved surfaces radially inwardly of the peripheral portion. Using such techniques, or other techniques, a charged particle element 520 can be provided in which the plurality of plates comprises a curved-surface plate with two curved surfaces having curvature in all directions for all positions within at least portions of the curved surfaces, optionally within at least portions of the curved surfaces in which the apertures 550 are defined.

In some embodiments, the plate stressor is configured to be controllable to allow the applied stresses to be adjusted. Adjusting the applied stresses may adjust the shape of one or both of the curved surfaces of the curved-surface plate. The applied stresses may be adjusted, for example, by adjusting a pressure applied between faces or spacers of a clamp (e.g., peripheral clamp) of the plate stressor.

Alternatively or additionally, other mechanisms may be used by plate stressor. For example, the plate stressor may be configured to vary a shape of one or both surfaces of the curved-surface plate by varying an electric field pressure applied to the curved-surface plate (e.g., by varying the electric field strength on one or both sides of the curved-surface plate). Alternatively or additionally, the plate stressor may be configured to vary a shape of one or both surfaces of the curved-surface plate by varying forces applied to the curved-surface plate by piezoelectric actuators. Alternatively or additionally, the plate stressor may be configured to vary a shape of one or both surfaces of the curved-surface plate by varying forces applied to the curved-surface plate by a bimetal arrangement. For example, the curved-surface plate may be configured to have structural elements formed of different metals on opposite sides of the curved-surface plate. The different metals may be selected to have different thermal expansion coefficients. Desired stresses can be applied to the curved-surface plate, for example to bend the plate into a desired shape, by suitably configuring the structural properties and/or shapes of the different metals and applying heat. The heat may be applied, for example, by driving an electric current through the metals.

In the arrangements described above with reference to **FIG. 4-16**, the curved-surface plates have curved surfaces on both sides. Typically, the two surfaces of each curved-surface plate are substantially parallel to each other, defining a curved plate of substantially uniform thickness. These arrangements may be particularly convenient where the curved surfaces are formed or adjusted by applying stresses to the plate (e.g., to bend the plate into a desired shape). In other arrangements, the two surfaces of the curved-surface plate may have non-parallel surfaces. One of the non-parallel surfaces may be substantially planar. Such surfaces may have surfaces of different topology, desirably one of the surfaces may have a flat topology. A plate having the surfaces may have varying thickness.

In an embodiment, the charged particle element 520 is provided as part of a module for a charged particle column for projecting the plurality of beams in the beam grid towards the sample 208. The element 520 may be a collimator 235. The collimator 235 may be configured to collimate diverging beam paths. The module may comprise a clamp for securing the curvature of the element 520 (e.g., of at least one plate of the element 520). The clamp may for example be configured as described above with reference to **FIG. 16.** A spacer may be provided between adjacent plates. The spacer may have a curved surface corresponding to a curved surface of a facing surface of the plurality of plates of the element 520. The clamp may clamp the spacer between adjacent plates or between a plate and a component other than one of the plurality of plates.

**FIG. 17** depicts an example arrangement. In the arrangement, two curved-surface plates 526 and 527 are provided. The uppermost curved-surface plate 526 comprises a planar surface 541 and a curved surface 542. The lowermost curved-surface plate 527 comprises a curved surface 543 and a planar surface 544. The curved surface 542 faces the curved surface 543. The curved surfaces 542, 543 may therefore be referred to as facing curved surfaces. The facing curved surfaces 542, 543 may be formed relatively easily into any desired shape, for example using known fabrication techniques. The challenges associated with forming curved surfaces having two-dimensional curvature by bending do not apply because the curved surfaces 542, 543 can be formed directly into the desired shape. The curved surfaces 542, 543 may thus have two-dimensional curvature or one-dimensional curvature. The curved surfaces 542, 543 with two dimensional curvature may have curvature that is cylindrically symmetric relative to a central axis (or path) along the path of the beam grid.

With two-dimensional curvature, the curved surfaces 542, 543 may be configured to provide focusing and/or defocusing functionality similar to that provided by the two curved-surface plates 521, 522 of **FIG. 13** or the two pairs of curved-surface plates 521, 522 and 524, 525 of **FIG. 14.** The curved surfaces 542, 543 may be configured such that there is a substantially constant separation between the curved surfaces 542, 543 at all points on the curved surfaces 542, 543, at least within a beam area through which the beam grid passes. The constant separation ensures a substantially uniform electric field strength between the curved surfaces 542, 543. Ensuring a substantially uniform electric field strength may facilitate control of the curved-surface plates to provide a desired lensing action, for example by making it easier to calculate the effect of the electric field on the beams of the beam grid. In an embodiment, the beam manipulator is configured to use the curved-surface plates 526, 527 to apply deflections that decrease an average divergence of beam paths from a principal axis of the beam grid, thereby applying a focusing effect to the beam grid. The focusing effect may be such as to collimate the beam grid.

The thicknesses of the curved-surface plates 526, 527 are shown in highly exaggerated forms in **FIG. 17** relative the width of the beam area through which the beam grid passes. In practice, the beam area could be greater than 10mm wide (for example in the range 1 to 20 mm) and the thickness less than 1mm. If the beams of the beam grid are slightly diverging or converging when they enter the apertures 550 of the curved-surface plates 526, 527, they may still pass through without the apertures 550 needing to be made excessively wide or angled, provided that the thickness of the plate is suitably small. Thus, as shown in **FIG. 17,** the curved-surface plates may be provided within apertures 550 that are aligned in a direction parallel to the principal axis of the beam grid (i.e., vertically in the orientation of **FIG. 17**) to provide parallel through holes in both of the curved-surface plates 526, 527. Parallel through holes may be made using known manufacturing techniques.

As depicted schematically in **FIG. 18,** a charged particle element according to any of the above-described embodiments may be incorporated into a charged particle device 41. The charged particle device 41 may take any of the forms described above, including any of the forms described with reference to **FIG. 3.** The charged particle device 41 may form part of a charged particle beam apparatus 40. In some embodiments, the device 41 comprises a condenser lens array 231 configured to generate the plurality of beams 211, 212, 213 of the beam grid from charged particles emitted by a source 201 and to focus the beams 211, 212, 213 at respective intermediate image positions 233 (i.e., in respective intermediate image planes, which may also be referred to as conjugate planes of the virtual source and/or intermediate foci). In such embodiments, the beam manipulator may be positioned to operate on beams 211, 212, 213 substantially at the intermediate image positions of the beams 211, 212, 213. Note that the depth of focus of the image in the intermediate image plane will typically be relatively large in comparison with the curvatures and separation of the facing surfaces of the curved-surface plates. This is illustrated schematically in **FIG. 6** by the range of positions labelled 577 for the case where the beams 211, 212, 213 are focused to intermediate image positions. The curved-surface plates of the beam manipulator can thus be positioned at a range of positions along the principal axis of the beam grid while still operating on beams substantially at the intermediate image positions of the beams.

The beam manipulator may be positioned, for example at or proximate to the intermediate foci of the beams, to operate on beams of the beam grid such as beams 211, 212, 213 to converge the paths of the beams down beam of the beam manipulator The beam manipulator may focus the different paths of the beams of the beam grid, even collimate the beam paths of the different beams of the beam grid, Since the beam manipulator operates on the different beams separately, in such an application the beam manipulator may be referred to as a collimator (or collimator array) 235. The beam manipulator may take the function of the deflectors of the collimator 235 of the arrangement shown in and described with reference to **FIG. 3.**

**FIG. 18** shows the beam manipulator comprising a pair of curved-surface plates 521, 522, but any of the configurations described above may be used, including more than two curved-surface plates, curved-surface plates having one-dimensional curvature and/or curved-surface plates having two-dimensional curvature.

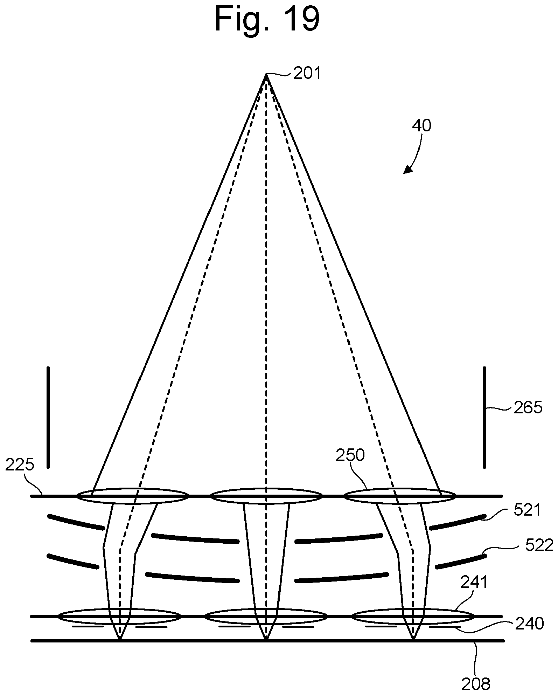

**FIG. 19** depicts a variation on the charged particle beam apparatus 40 of **FIG. 18** in which the array of condenser lenses 231 is omitted. A beam limiting aperture array 225 is provided at a control lens array 250. The beam limiting aperture array 225 forms a plurality of beams of the beam grid. A macro deflector 265 is provided upbeam of the control lens array 250 and beam limiting aperture array 225. An objective lens array 241 downbeam of the control lens array 250 projects the beams of the beam grid onto the sample 208. The control lens array 241 may be considered to be part of the objective lens array 241 in providing extra degrees of freedom to the control of the objective lenses of the objective lens array 241. A detector array 240 detects signal charged particles emitted from the sample 208. A beam manipulator according to any of the embodiments of the present disclosure may be provided between the control lens array 250 and the objective lens array 241, for example as part of the objective lens array. In the example shown, the beam manipulator comprises two curved-surface plates 521 and 522 but may take any of the forms described above. In the example shown, the beam manipulator applies deflections to beams of the beam grid to decrease an average divergence from a principal axis of the beam grid, thereby applying a focusing effect to the beam grid. The focusing effect is such as to collimate the beam grid. In an embodiment, the beam manipulator may serve as a collimator 235, for example a collimator array for operating on each beam of the beam grid separately. That is the aperture array in the plates of the beam manipulator may have an aperture for each different aperture of the aperture array.

In an embodiment, a charged particle beam apparatus array is provided. The array may comprise a plurality of any of the charged particle beam apparatuses 40 described herein for example as described with respect to any of **FIGs 3, 18 and 19**; where an arrangement corresponding to **FIG.3** features a beam manipulator as shown and described herein for example with respect to **FIGs 8 to 10,** 13 to 15 and 17. Each charged particle beam apparatus 40 may comprise a source 201 configured to emit charged particles and a charged particle device 41 configured to project a plurality of charged particle beams (derived from the source 201) in a beam grid towards a sample 208. (In a different arrangement the charged particle device 41 may comprise a respective source 201). The charged particle beam apparatuses 40 in the array may project respective beam grids simultaneously onto different regions of the same sample. Each charged particle beam apparatus 40 may form a beam grid comprising a plurality of beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The projecting of plural beam grids simultaneously onto different regions of the same sample allows an increased area of the sample 208 to be processed (e.g. assessed) simultaneously. The charged particle beam apparatuses 40 in the array may be arranged adjacent to each other so as to project the respective beam grids onto adjacent regions of the sample 208. The arrangement of the charged particle beam apparatuses 40 may be in regular grid such as a rectangular grid or a hexagonal grid. Any number of charged particle beam apparatuses 40 may be used in the array 500. Preferably, the number of charged particle beam apparatuses 40 is in the range of from 2 (preferably 9) to 200. Each charged particle beam apparatus 40 in the array 500 may be configured in any of the ways described herein when referring to a single charged particle beam apparatus 40, for example as described above, especially with respect to the embodiments shown and described with reference to **FIG. 18** and **FIG. 19.**

References to up and low, upper and lower, lowest, up and down, above and below should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field. Such directions are intended to be independent of the presence of electrons, and thus of the beam or the apparatus being operational.

Any reference to a charged particle herein is understood to encompass at least an electron as the charged particle.

References to elements being aligned along a beam path or sub-beam path are understood to mean that the respective elements are positioned along the beam path or sub-beam path.

An assessment system 100 according to any embodiment of the disclosure may be a tool which makes a qualitative assessment of a sample (e.g. pass/fail), one which makes a quantitative measurement (e.g. the size of a feature) of a sample or one which generates an image of map of a sample. Thus, the assessment system 100 could be any appropriate device, apparatus or system used for assessment. For example, the assessment system 100 could be any of the charged particle beam apparatus 40, or more specifically the charged particle optical device 41, and/or as part of an optical lens array assembly, when used for assessment. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The charged particle beam device 40 (which may be a charged particle-optical column) may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, and the condenser lens 231, under the control of the controller or control system or control unit. An actuatable component, such as a stage, may be controllable to actuate and thus move relative to another component such as the beam path using one or more controllers, control systems, or control units to control the actuation of the component.

The embodiments herein described comprising a detector assembly may take the form of a series of aperture arrays or charged particle optical elements arranged in arrays along a beam or a multi-beam path. Such charged particle optical elements may be electrostatic. In an embodiment all the charged particle optical elements, for example from a beam limiting aperture array to a last charged particle optical element in a sub-beam path before a sample, may be electrostatic and/or may be in the form of an aperture array or a plate array. In some arrangements one or more of the charged particle optical elements are manufactured as a microelectromechanical system (MEMS) (i.e. using MEMS manufacturing techniques).

The system or device of such architectures as depicted in at least **FIG. 3** and as described above may comprise components such as an up-beam beam limiter, a control lens array 250, an objective lens array 241, a beam shaping limiter and/or a detector array and/or detector assembly; one or more of these elements that are present may be connected to one more adjacent elements with an isolating element such as a ceramic or glass spacer.

Any element or collection of elements may be replaceable or field replaceable within the charged particle beam tool, for example with the charged particle device 40. The one or more charged particle optical components in the charged particle beam tool for example with the charged particle device 40, especially those that operate on sub-beams or generate sub-beams, such as aperture arrays and manipulator arrays may comprise one or more MEMS.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:

Clause 1. A charged particle element for projecting a plurality of charged particle beams in a beam grid towards a sample, the element comprising: a beam manipulator configured to operate on a plurality of charged particle beams in a beam grid, the beam manipulator comprising a plurality of plates across paths of the beams, each plate having two surfaces in which are defined a plurality of apertures for operating on the beams and allowing the beams to pass through the plates, wherein: the plurality of plates comprises at least one curved-surface plate, the curved-surface plate being configured such that at least one of the two surfaces of the curved-surface plate is a curved surface and the curved surface faces a facing surface of an adjacent plate; and the beam manipulator is configured to apply deflections to beams of the beam grid by controlling a potential difference applied between the curved surface and the facing surface.

Clause 2. The element of clause 1, wherein the beam manipulator is configured such that the deflection applied to each deflected beam of the beam grid is defined by the position of the aperture in the curved surface that corresponds to that deflected beam, the position of the aperture defining a local inclination of the curved surface adjacent to the aperture.

Clause 3. The element of clause 1 or 2, wherein the beam manipulator is configured such that the applied deflections apply a focusing effect to the beam grid, for example decrease an average divergence of beam paths from a principal axis of the beam grid.

Clause 4. The element of clause 3, wherein the focusing effect is such as to collimate the beam grid.

Clause 5. The element of clause 1 or 2, wherein the beam manipulator is configured such that the applied deflections apply a defocusing effect to the beam grid, for example increase an average divergence of beam paths from a principal axis of the beam grid.

Clause 6. The element of clause 5, wherein the defocusing effect is such that when a collimated beam grid is input to the beam manipulator in use the defocusing effect causes the beam manipulator to output an uncollimated beam grid.

Clause 7. The element of any preceding clause, wherein the beam manipulator is configured such that the potential difference applied between the curved surface and the facing surface defines an electric field that is of substantially uniform strength over the curved surface.

Clause 8. The element of any preceding clause, wherein both of the two surfaces of the curved-surface plate are curved surfaces, desirably each with at least one dimension of curvature.

Clause 9. The element of clause 8, wherein the two surfaces of the curved-surface plate are substantially parallel to each other, thereby defining a curved plate of substantially uniform thickness.

Clause 10. The element of any of clauses 1 to 8, wherein the plate has varying thickness and/or the two surfaces of the curved-surface plate have different topology for example have non-parallel surfaces.

Clause 11. The element of clause 10, where one of the surfaces of the curved surface plate is substantially planar, desirably wherein one of the surfaces of the curved surface plate has at least a portion which is concave or convex, the plurality of apertures being defined in the portion.

Clause 12. The element of any preceding clause, wherein the plurality of plates that comprise at least one curved-surface plate comprise one or more pairs of curved-surface plates, each pair of curved-surface plates defining a respective pair of facing curved surfaces.

Clause 13. The element of clause 12, wherein for one or more of the pairs of curved-surface plates, each respective pair of facing curved surfaces have zero curvature along the same direction at all points on the facing curved surfaces.

Clause 14. The element of clause 13, wherein each pair of facing curved surfaces having zero curvature along the same direction at all points on the facing curved surfaces is configured such that a separation between the facing curved surfaces is the same at all positions on the facing curved surfaces.

Clause 15. The element of any of clauses 12 to 14, wherein for one or more of the pairs of curved-surface plates, one of the facing curved surfaces of each pair has zero curvature along a first direction at all points on the facing curved surface and the other of the facing curved surfaces has zero curvature along a second direction at all points on the facing curved surface, the first direction being different to the second direction.

Clause 16. The element of clause 15, wherein the first direction and the second direction have different rotational orientations, the rotational orientations being defined relative to an axis along the path of the beam grid, optionally relative to a principal axis of the beam grid.

Clause 17. The element of clause 16, wherein the first direction is rotated by 60 degrees or 90 degrees, and/or by a principal angle of the beam grid, relative to the second direction about the principal axis of the beam grid.

Clause 18. The element of any of clauses 12 to 17, wherein the element is configured to apply potential differences of opposite polarity between different pairs of facing curved surfaces to reduce or avoid changes in beam energy of the beams of the beam grid by the beam manipulator.

Clause 19. The element of any of clauses 12 to 18, wherein:the plurality of plates comprising one or more pairs of curved-surface plates comprises a first pair of curved-surface plates and a second pair of curved-surface plates; the facing surfaces of the first pair both have zero curvature along a first common direction at all points on the facing surfaces; the facing surfaces of the second pair both have zero curvature along a second common direction at all points on the facing surfaces; and the first common direction is perpendicular or oblique to the second common direction, optionally rotated relative to the second common direction about the principal axis of the beam grid, optionally by a principal angle of the beam grid such as 60 degrees or 90 degrees.

Clause 20. The element of clause 19, wherein the facing surfaces of the first pair are convex in an opposite direction to the facing surfaces of the second pair and the element is configured to accelerate charged particles between facing surfaces of one of the two pairs and to decelerate charged particles between facing surfaces of the other of the two pairs.

Clause 21. The element of any of clauses 12 to 20, wherein: a curvature of each facing curved surface of one or more of the pairs of curved-surface plates is such that the facing curved surface deviates from a reference plane; the reference plane is a plane perpendicular to the path of the beam grid and passing through the respective facing curved surface where the facing curved surface intersects a principal axis of the beam grid; and the deviation from the reference plane is defined, for each portion of the facing curved surface, as a separation between the reference plane and the portion of the facing curved surface in a deviation direction parallel to the principal axis of the beam grid, the deviation varying in magnitude as a function of distance of the portion of the facing curved surface from the principal axis of the beam grid according to the curvature of the facing curved surface.

Clause 22. The element of clause 21, wherein one or more of the facing curved surfaces is configured such that the deviations from the reference plane are in the same direction for all portions of the facing curved surface.

Clause 23. The element of clause 21 or 22, wherein the facing curved surfaces of one of the pairs of curved-surface plates are configured such that the deviations from the respective reference plane are in opposite directions to each other aligned with the principal axis of the beam grid, optionally substantially equal in average magnitude, optionally substantially equal in magnitude for all portions of the facing curved surfaces.

Clause 24. The element of any of clauses 21 to 23, wherein the facing curved surfaces of one of the pairs of curved-surface plates are configured such that the deviations from the respective reference planes are in the same direction for each of the two facing curved surfaces, optionally such that a separation between the facing curved surfaces of the pair is the same at all positions on the facing curved surfaces.

Clause 25. The element of any of clauses 21 to 24, wherein one or more of the facing curved surfaces has one-dimensional curvature, defined as a curvature for which deviations from the respective reference plane are uniform as function of position in the facing curved surface along a common direction for all portions of the facing curved surface.

Clause 26. The element of any of clauses 21 to 25, wherein one or more of the facing curved surfaces is configured to have two-dimensional curvature, defined as a curvature for which deviations from the respective reference plane vary as a function of position in all directions for at least one portion of the facing curved surface.

Clause 27. The element of any preceding clause, wherein the curved surface of one or more of the at least one curved-surface plate has zero curvature along a common direction along the curved surface at all positions on the curved surface.

Clause 28. The element of any preceding clause, wherein: the curved surface is cylindrically symmetric relative to a principal axis of the beam grid; or the curved surface of one or more of the at least one curved-surface plates has non-zero curvature in all directions along the curved surface for all positions within at least a portion of the curved surface, optionally such that the curved surface is cylindrically symmetric relative to a principal axis of the beam grid.

Clause 29. The element of any preceding clause, further comprising a plate stressor (desirably theT stressor) is configured to apply stresses to one of the at least one curved-surface plate to define a shape of one or both curved surfaces of the curved-surface plate, desirably the plate stressor being configured to support and/or secure in position the curved-surface plate.

Clause 30. The element of clause 29, wherein the plate stressor is configured to be controllable to allow the applied stresses to be adjusted, thereby adjusting the shape of one or both of the curved surfaces of the curved-surface plate.

Clause 31. The element of clause 29 or 30, wherein the plate stressor comprises a peripheral clamp configured to apply the stresses via clamping of a periphery of the curved-surface plate.

Clause 32. The element of any of clauses 29 to 31, wherein the plate stressor comprises a spacer, the spacer comprising a body having two surfaces in which are defined an aperture for the passage of a plurality of charged particle beams in a beam grid, wherein the body has a curvature representing a deviation from a planar form across one or both surfaces of the body, the plate stressor being optionally configured to clamp the spacer against the curved-surface plate to apply the stresses to the curved-surface plate.

Clause 33. The element of any of clauses 29 to 32, wherein the plate stressor is configured to define the shape of one or both curved surfaces of the curved-surface plate to have curvature in all directions along the curved surface or curved surfaces for all positions within at least a portion of the curved surface or curved surfaces, optionally such that the curved surface or curved surfaces is or are cylindrically symmetric relative to a principal axis of the beam grid.

Clause 34. The element of clause 33, wherein the peripheral clamp is configured to clamp a peripheral portion of the curved-surface plate to apply a deformation to the curved-surface plate desirably at the peripheral portion, desirably the deformation comprising displacing a plurality of displacement portions of the peripheral portion, desirably axially.

Clause 35. The element of clause 34, wherein the displacement portions are substantially identical to each other and/or distributed uniformly around a periphery of the curved-surface plate and/or distributed to have rotational symmetry of order greater than one relative to a principal axis of the beam grid.

Clause 36. A charged particle element for projecting a plurality of charged particle beams in a beam grid towards a sample, the element comprising: a plurality of plates positioned across a path of a plurality of beams of charged particles in a beam grid, each plate having two surfaces in which are defined a plurality of apertures for passage of the beams of the beam grid through the plates, the plurality of plates comprising an electron-optical component for operating on the beams of the beam grid, wherein: the plurality of plates comprise a curved-surface plate with two curved surfaces having curvature in all directions for all positions within at least portions of the curved surfaces, optionally within at least portions of the curved surfaces in which the apertures are defined.

Clause 37. The element of clause 36, wherein the curved-surface plate has uniform thickness.

Clause 38. The element of clause 36 or 37, wherein the curved surfaces are cylindrically symmetric relative to a principal axis of the beam grid.

Clause 39. The element of any of clauses 36 to 38, further comprising a plate stressor configured to apply stresses to the curved-surface plate to define the curvature and/or shapes of the curved surfaces.

Clause 40. The element of clause 39, wherein the plate stressor is configured to clamp the curved-surface plate to define the curvature and/or shapes of the curved surfaces, desirably the plate stressor comprises a peripheral clamp configured to clamp a peripheral portion of the curved-surface plate to define the curvature and/or shapes of the curved surfaces.

Clause 41. The element of clause 40, wherein the peripheral clamp is configured to deform the peripheral portion of the curved-surface plate to impart a deformation defining curvatures and/or the shapes of the curved surfaces radially inwardly of the peripheral portion.

Clause 42. The element of clause 41, wherein the deformation comprises displacing a plurality of displacement portions of the peripheral portion, desirably axially.

Clause 43. The element of clause 42, wherein the displacement portions are substantially identical to each other and/or distributed uniformly around a circumference of the curved-surface plate and/or distributed to have rotational symmetry of order greater than one relative to a principal axis of the beam grid.

Clause 44. A charged particle device for projecting a plurality of charged particle beams in a beam grid towards a sample, the device comprising: the element of any preceding clause, configured such that the beam manipulator is positioned to operate on beams substantially at the intermediate focus plane and/or intermediate image positions of the beams and/or configured to operate as a collimator array desirably so as to operate on the different beams of the beam grid, desirably different apertures defined in the plurality of plates operating on different respective beams of the beam grid.

Clause 45. The device of clause 44, wherein the device comprises a condenser lens array configured to generate the plurality of beams of the beam grid from charged particles emitted by a source and to focus the beams at respective intermediate image positions.

Clause 46. A charged particle beam apparatus array comprising: a plurality of charged particle beam apparatuses, each charged particle beam apparatus comprising: a source configured to emit charged particles; and a charged particle device configured to project a plurality of charged particle beams in a beam grid towards a sample, wherein: each charged particle device comprises the element of any of clauses 1 to 43; and the charged particle devices are configured to project respective beam grids simultaneously onto different regions of the same sample.

Clause 47. A spacer for supporting a plate of an electron-optical element for use in a multibeam inspection system, the spacer comprising a body having two surfaces in which are defined an aperture for the passage of a plurality of charged particle beams in a beam grid, wherein the body has a curvature representing a deviation from a planar form across one or both surfaces of the body.

Clause 48. A method of projecting a plurality of charged particle beams in a beam grid towards a sample, the method comprising: operating on a plurality of charged particle beams in a beam grid using a plurality of plates across paths of the beams, each plate having two surfaces in which are defined a plurality of apertures for operating on the beams and allowing the beams to pass through the plates, wherein: the plurality of plates comprises at least one curved-surface plate, the curved-surface plate being configured such that at least one of the two surfaces of the curved-surface plate is a curved surface and the curved surface faces a facing surface of an adjacent plate; and the method comprises applying deflections to beams of the beam grid by controlling a potential difference applied between the curved surface and the facing surface (or the operating comprising applying deflections to beams of the beam grid by controlling a potential difference applied between the curved surface and the facing surface).

Clause 49. A method of projecting a plurality of charged particle beams in a beam grid towards a sample, the method comprising: electrostatically operating on a plurality of charged particle beams in a beam grid using a plurality of plates across paths of the beams, each plate having two surfaces in which are defined a plurality of apertures for operating on the beams and allowing the beams to pass through the plates, wherein: the plurality of plates comprise a curved-surface plate with two curved surfaces having curvature in all directions for all positions within at least portions of the curved surfaces, optionally within at least portions of the curved surfaces in which the apertures are defined.

Clause 50. A charged particle element for adjusting the paths of different beams of a beam grid projected towards a sample the element comprising: a plurality of plates across paths of a plurality of beams of the beam grid, in the plurality of plates are defined a plurality of apertures for operating on the beams and allowing the beams to pass through the plates, adjoining plates of the plurality of plates having facing surfaces, wherein: one or both of the facing surfaces are curved; and the element is configured to apply a deflection to paths of different beams of the beam grid by controlling a potential difference applied between the respective facing curved surfaces.

Clause 51. A charged particle element of clause 50 wherein facing surfaces are curved in opposite directions and/or the element is configured to focus the different paths of the beams of the grid.

Clause 52. A charged particle element of clause 50 or 51, wherein the element is configured to focus the different paths of the beams of the grid.

Clause 53. A charged particle element of any of clauses 50 to 52, wherein at least two of the plurality of plates are curved in the same direction and/or in different directions common to the beam path.

Clause 54. A charged particle element of any of clauses 50 to 53, wherein at least two of the plates are cylindrically curved, in different axes or the same axes across the beam path.

Clause 55. A charged particle element of any of clauses 50 to 54, wherein at least one of the plates is curved in two different directions across the beam paths.

Clause 56. A charged particle element of any of clauses 50 to 55, wherein the electric field applied between facing surfaces is configured to be controlled.

Clause 57. A charged particle element of any of clauses 50 to 56, wherein different plates are curved so as to be configured to maintain the beam energies of the different beams.

Clause 58. A module for charged particle column for projecting a plurality of beams in a beam grid towards a sample, the module comprising a charged particle element for adjusting the paths of different beams of the beam grid, the element comprising: a plurality of plates across paths of a plurality of beams of the beam grid, in the plurality of plates are defined a plurality of apertures for operating on the beams and allowing the beams to pass through the plates, adjoining plates of the plurality of plates having facing surfaces, wherein: one or both of the facing surfaces are curved; and the element is configured to apply a deflection to paths of different beams of the beam grid by controlling a potential difference applied between the respective facing curved surfaces.

Clause 59. The module of clause 58, wherein the element is a collimator configured to collimate diverging beam paths.

Clause 60. The module of clause 58 or 59, further comprising a clamp for securing the curvature of the element.

Clause 61. The module of clause 58, 59 or 60 further comprising a spacer between adjacent plates, the spacer having a curved surface corresponding to curved surface of the facing surfaces.

Clause 62. The module of clause 60 or 61 further comprising a clamp for securing the curvature of at least one plate of the element, the clamp spacer between adjacent plates, the spacer having a curved surface corresponding to curved surface of the facing surfaces.

## Claims

1. A charged particle element for projecting a plurality of charged particle beams in a beam grid towards a sample, the element comprising:
   a beam manipulator configured to operate on a plurality of charged particle beams in a beam grid, the beam manipulator comprising a plurality of plates across paths of the beams, each plate having two surfaces in which are defined a plurality of apertures for operating on the beams and allowing the beams to pass through the plates, wherein:

   the plurality of plates comprises at least one curved-surface plate, the curved-surface plate being configured such that at least one of the two surfaces of the curved-surface plate is a curved surface and the curved surface faces a facing surface of an adjacent plate; and
   the beam manipulator is configured to apply deflections to beams of the beam grid by controlling a potential difference applied between the curved surface and the facing surface.

2. The element of claim 1, wherein the beam manipulator is configured such that the deflection applied to each deflected beam of the beam grid is defined by the position of the aperture in the curved surface that corresponds to that deflected beam, the position of the aperture defining a local inclination of the curved surface adjacent to the aperture.

3. The element of claim 1 or 2, wherein the beam manipulator is configured such that the applied deflections apply a focusing effect to the beam grid, for example decrease an average divergence of beam paths from a principal axis of the beam grid, desirably wherein the focusing effect is such as to collimate the beam grid.

4. The element of claim 1 or 2, wherein the beam manipulator is configured such that the applied deflections apply a defocusing effect to the beam grid, for example increase an average divergence of beam paths from a principal axis of the beam grid.

5. The element of any preceding claim, wherein the beam manipulator is configured such that the potential difference applied between the curved surface and the facing surface defines an electric field that is of substantially uniform strength over the curved surface.

6. The element of any preceding claim, wherein both of the two surfaces of the curved-surface plate are curved surfaces desirably each with at least one dimension of curvature.

7. The element of any of claims 1 to 6, wherein the plate has varying thickness and/or the two surfaces of the curved-surface plate have different topology for example have non-parallel surfaces.

8. The element of any preceding claim, wherein the plurality of plates that comprise at least one curved-surface plate comprise one or more pairs of curved-surface plates, each pair of curved-surface plates defining a respective pair of facing curved surfaces.

9. The element of claim 8, wherein for one or more of the pairs of curved-surface plates, each respective pair of facing curved surfaces have zero curvature along the same direction at all points on the facing curved surfaces.

10. The element of claim 8 or 9, wherein for one or more of the pairs of curved-surface plates, one of the facing curved surfaces of each pair has zero curvature along a first direction at all points on the facing curved surface and the other of the facing curved surfaces has zero curvature along a second direction at all points on the facing curved surface, the first direction being different to the second direction.

11. The element of claim 10, wherein the first direction and the second direction have different rotational orientations, the rotational orientations being defined relative to an axis along the path of the beam grid, optionally relative to a principal axis of the beam grid.

12. The element of any of claims 8 to 11, wherein the element is configured to apply potential differences of opposite polarity between different pairs of facing curved surfaces to reduce or avoid changes in beam energy of the beams of the beam grid by the beam manipulator.

13. The element of any preceding claim, wherein: the curved surface is cylindrically symmetric relative to a principal axis of the beam grid; or the curved surface of one or more of the at least one curved-surface plates has non-zero curvature in all directions along the curved surface for all positions within at least a portion of the curved surface, optionally such that the curved surface is cylindrically symmetric relative to a principal axis of the beam grid.

14. The element of any preceding claim, further comprising a plate stressor desirably the stressor is configured to apply stresses to one of the at least one curved-surface plate to define a shape of one or both curved surfaces of the curved-surface plate, desirably the plate stressor being configured to support and/or secure in position the curved-surface plate.

15. A method of projecting a plurality of charged particle beams in a beam grid towards a sample, the method comprising: operating on a plurality of charged particle beams in a beam grid using a plurality of plates across paths of the beams, each plate having two surfaces in which are defined a plurality of apertures for operating on the beams and allowing the beams to pass through the plates, wherein:

the plurality of plates comprises at least one curved-surface plate, the curved-surface plate being configured such that at least one of the two surfaces of the curved-surface plate is a curved surface and the curved surface faces a facing surface of an adjacent plate; and
the operating comprising applying deflections to beams of the beam grid by controlling a potential difference applied between the curved surface and the facing surface.

# Fig. 1

# Fig. 2

# Fig. 3

# Fig. 4

# Fig. 5

# Fig. 6

# Fig. 7

# Fig. 8

$U_1 < U_2$

$U_1$

$U_2$

531
532
533
534
521
522

# Fig. 9

$U_1$

$U_1 > U_2$

531
532
533
521

$U_2$

535
536
523

# Fig. 10

$U_1$

$U_1 > U_2 < U_3$

531
532
521

$U_2$

535
536
523

533
534
522

$U_3$

# Fig. 11

540

541

542

# Fig. 12

540

541

544

542

# Fig. 13

521

551

$U_1$

532

533

$U_2$

552

522

# Fig. 14

# Fig. 15

# Fig. 16

560

562

562

562

562

562

564

564

564

564

564

564

# Fig. 17

541

550

526

543

542

544

527

# Fig. 18

# Fig. 19

Europäisches Patentamt

European Patent Office

Office européen des brevets

# EUROPEAN SEARCH REPORT

**Application Number**

EP 23 21 1553

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 270 834 B1 (ZEISS CARL SMT GMBH [DE]; APPLIED MATERIALS ISRAEL LTD [IL]) 23 January 2013 (2013-01-23) * paragraph [0121]; figures * * paragraph [0202] * * paragraph [0204] * * paragraph [0214] * | 1-5,7,8, 12,13,15 | INV. H01J37/147 H01J37/28 |
| X | EP 1 602 121 B1 (MAPPER LITHOGRAPHY IP BV [NL]) 27 June 2012 (2012-06-27) | 1-6,8, 12,15 | |
| Y | * paragraph [0011]; figure 10B * * paragraph [0049] * * paragraph [0058] - paragraph [0060] * | 9,13 | |
| X | US 2012/145915 A1 (VAN VEEN ALEXANDER HENDRIK VINCENT [NL] ET AL) 14 June 2012 (2012-06-14) * paragraphs [0076] - [0089]; figures 2,5-8 * | 1-5,7,15 | |
| X | GB 2 031 221 A (PHILIPS NV) 16 April 1980 (1980-04-16) * page 2, lines 30-43; figures 1,2 * | 1-6,8, 12,15 | TECHNICAL FIELDS SEARCHED (IPC) H01J |
| Y | US 2 957 106 A (MOODEY HANNAH C) 18 October 1960 (1960-10-18) | 9,13 | |
| A | * column 5 - column 6; figure 4 * | 10,11 | |
| A | US 5 825 123 A (RETSKY MICHAEL W [US]) 20 October 1998 (1998-10-20) * figure 8 * | 9-11,13 | |

The present search report has been drawn up for all claims

| Place of search | Date of completion of the search | Examiner |
|---|---|---|
| Munich | 19 July 2024 | Schmidt-Kärst, S |

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-13, 15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**

**SHEET B**

**Application Number**

EP 23 21 1553

The Search Division considers that the present European patent application does not comply with the requirements of unity of invention and relates to several inventions or groups of inventions, namely:

1. claims: 1-8, 12, 15(completely); 13(partially)

   A charged particle element as defined in claim 1 and its method of operation, comprising a beam manipulator including a plurality of plates that comprises at least one curved-surface plate, the curved-surface plate being configured such that at least one of the two surfaces of the curved-surface plate is a curved surface and the curved surface faces a facing surface of an adjacent plate, wherein
   - both of the two surfaces of the curved-surface plate are curved surfaces; or
   - the plate having a curved surface has varying thickness; or
   - the plurality of plates comprise one or more pairs of curved-surface plates, each pair of curved-surface plates defining a respective pair of facing curved surfaces; or
   - the curved surface of one or more of the at least one curved-surface plates has non-zero curvature in all directions along the curved surface for all positions within at least a portion of the curved surface.
   - - -

2. claims: 9-11(completely); 13(partially)

   A charged particle element as defined in claim 1 and its method of operation, comprising a beam manipulator including a plurality of plates that comprises at least one curved-surface plate, the curved-surface plate being configured such that at least one of the two surfaces of the curved-surface plate is a curved surface and the curved surface faces a facing surface of an adjacent plate, wherein
   - the curved surface is cylindrically symmetric relative to a principal axis of the beam grid; or
   - for one or more of the pairs of curved-surface plates, each respective pair of facing curved surfaces have zero curvature along the same direction at all points on the facing curved surfaces.
   - - -

3. claim: 14

   A charged particle element as defined in claim 1 and its method of operation, comprising a beam manipulator including a plurality of plates that comprises at least one curved-surface plate, the curved-surface plate being configured such that at least one of the two surfaces of the curved-surface plate is a curved surface and the curved surface faces a facing surface of an adjacent plate, further comprising a plate stressor.
   - - -

## ANNEX TO THE EUROPEAN SEARCH REPORT
## ON EUROPEAN PATENT APPLICATION NO.

EP 23 21 1553

This annex lists the patent family members relating to the patent documents cited in the above-mentioned European search report.
The members are as contained in the European Patent Office EDP file on
The European Patent Office is in no way liable for these particulars which are merely given for the purpose of information.

19-07-2024

| Patent document cited in search report | | Publication date | Patent family member(s) | | Publication date |
|---|---|---|---|---|---|
| EP 2270834 | B1 | 23-01-2013 | AT | E503265 T1 | 15-04-2011 |
| | | | AT | E545147 T1 | 15-02-2012 |
| | | | EP | 1941528 A2 | 09-07-2008 |
| | | | EP | 1943661 A1 | 16-07-2008 |
| | | | EP | 2267751 A2 | 29-12-2010 |
| | | | EP | 2267752 A2 | 29-12-2010 |
| | | | EP | 2270833 A2 | 05-01-2011 |
| | | | EP | 2270834 A2 | 05-01-2011 |
| | | | JP | 5222142 B2 | 26-06-2013 |
| | | | JP | 5663717 B2 | 04-02-2015 |
| | | | JP | 5728660 B2 | 03-06-2015 |
| | | | JP | 2009507351 A | 19-02-2009 |
| | | | JP | 2009507352 A | 19-02-2009 |
| | | | JP | 2012234827 A | 29-11-2012 |
| | | | US | 2009114818 A1 | 07-05-2009 |
| | | | US | 2009256075 A1 | 15-10-2009 |
| | | | US | 2015008331 A1 | 08-01-2015 |
| | | | US | 2016240344 A1 | 18-08-2016 |
| | | | WO | 2007028595 A2 | 15-03-2007 |
| | | | WO | 2007028596 A1 | 15-03-2007 |
| EP 1602121 | B1 | 27-06-2012 | CN | 1759465 A | 12-04-2006 |
| | | | EP | 1602121 A2 | 07-12-2005 |
| | | | EP | 2503587 A2 | 26-09-2012 |
| | | | JP | 4484868 B2 | 16-06-2010 |
| | | | JP | 2006520078 A | 31-08-2006 |
| | | | KR | 20050102688 A | 26-10-2005 |
| | | | US | 7348567 B1 | 25-03-2008 |
| | | | US | 2004232349 A1 | 25-11-2004 |
| | | | US | 2007018112 A1 | 25-01-2007 |
| | | | US | 2007029499 A1 | 08-02-2007 |
| | | | US | 2007029509 A1 | 08-02-2007 |
| | | | WO | 2004081910 A2 | 23-09-2004 |
| US 2012145915 | A1 | 14-06-2012 | TW | 201234401 A | 16-08-2012 |
| | | | US | 2012145915 A1 | 14-06-2012 |
| | | | WO | 2012062854 A1 | 18-05-2012 |
| GB 2031221 | A | 16-04-1980 | CA | 1135766 A | 16-11-1982 |
| | | | DD | 145819 A5 | 07-01-1981 |
| | | | DE | 2934993 A1 | 20-03-1980 |
| | | | ES | 483938 A1 | 01-03-1980 |
| | | | FR | 2435808 A1 | 04-04-1980 |
| | | | GB | 2031221 A | 16-04-1980 |
| | | | IT | 1123551 B | 30-04-1986 |
| | | | JP | H0332174 B2 | 10-05-1991 |

EPO FORM P0459

For more details about this annex : see Official Journal of the European Patent Office, No. 12/82

page 1 of 2

**ANNEX TO THE EUROPEAN SEARCH REPORT
ON EUROPEAN PATENT APPLICATION NO.**                    EP 23 21 1553

This annex lists the patent family members relating to the patent documents cited in  the above-mentioned European search report.
The members are as contained in the European Patent Office EDP file on
The European Patent Office is in no way liable for these particulars which are merely given for the purpose of information.

19-07-2024

| Patent document cited in search report | | Publication date | Patent family member(s) | | Publication date |
|---|---|---|---|---|---|
| | | | JP | S5537798 A | 15-03-1980 |
| | | | NL | 7809160 A | 11-03-1980 |
| | | | US | 4291251 A | 22-09-1981 |
| US 2957106 | A | 18-10-1960 | NONE | | |
| US 5825123 | A | 20-10-1998 | NONE | | |

EPO FORM P0459

For more details about this annex : see Official Journal of the European Patent Office, No. 12/82

page 2 of 2

**EP 4 560 682 A1**

**REFERENCES CITED IN THE DESCRIPTION**

**Patent documents cited in the description**

- WO 2021204734 A
- US 20230238215 A1
- US 20210319977 A
- US 2020118784 A
- US 20200203116 A
- US 20190259570 A
- US 20190259564 A
- EP 1602121 A1
- US 20230290609 A1
- US 20220196581 A1
- US 20100276606 A